(19) Europäisches Patentamt / European Patent Office / Office européen des brevets

(11) **EP 2 982 774 A1**

(12) **EUROPEAN PATENT APPLICATION**
published in accordance with Art. 153(4) EPC

(43) Date of publication:
**10.02.2016 Bulletin 2016/06**

(51) Int Cl.:
***C23C 14/08*** (2006.01)   ***B32B 9/00*** (2006.01)

(21) Application number: **14779674.2**

(22) Date of filing: **28.03.2014**

(86) International application number:
**PCT/JP2014/059178**

(87) International publication number:
**WO 2014/163009 (09.10.2014 Gazette 2014/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **04.04.2013   JP 2013078330**
**19.09.2013   JP 2013193709**
**20.09.2013   JP 2013195395**

(71) Applicant: **Toray Industries, Inc.**
**Tokyo 103-8666 (JP)**

(72) Inventors:
• **TOKUNAGA, Kodai**
  **Otsu-shi**
  **Shiga 520-8558 (JP)**
• **UEBAYASHI, Hiroyuki**
  **Otsu-shi**
  **Shiga 520-8558 (JP)**
• **SATAKE, Hikaru**
  **Otsu-shi**
  **Shiga 520-8558 (JP)**
• **SUZUKI, Motoyuki**
  **Otsu-shi**
  **Shiga 520-8558 (JP)**

(74) Representative: **Kador & Partner**
**Corneliusstraße 15**
**80469 München (DE)**

(54) **GAS BARRIER FILM AND METHOD FOR PRODUCING SAME**

(57)    An object of the present invention is to provide a gas barrier film which is less likely to undergo loss of gas barrier property when it is bent and which exhibits high transparency and high gas barrier property.

A gas barrier film comprising a polymer film substrate and a gas barrier layer containing at least zinc oxide and silicon dioxide on at least one surface of the polymer film substrate, wherein the gas barrier layer satisfies at least one of the following [I] to [III]:

[I] with regard to X-ray absorption near edge structure (XANES) spectrum at K absorption edge of zinc, the value of (spectrum intensity at 9664.0 eV) / (spectrum intensity at 9668.0 eV) is in the range of 0.910 to 1.000;

[II] the value obtained by dividing atomic concentration of zinc with atomic concentration of silicon is in the range of 0.1 to 1.5, and structural density index represented by the following equation:

```
structural density index = {density of the gas barrier
layer obtained by X-ray reflectometry (XRR)} / {(theoretical
density calculated from compositional ratio determined by X-ray
photoelectron spectroscopy (XPS)} is 1.20 to 1.40; and
```

[III] when peak in the wave number range of 900 to 1,100 cm$^{-1}$ measured in FT-IR measurement is subjected to peak separation into the wave number of 920 cm$^{-1}$ and the wave number of 1,080 cm$^{-1}$, the value of ratio (A/B) of integrated intensity of the spectrum having its peak at 920 cm$^{-1}$ (A) to integrated intensity of the spectrum having its peak at 1, 080 cm$^{-1}$ (B) is at least 1.0 and up to 7.0.

EP 2 982 774 A1

[Fig. 1]

**Description**

Technical Field

The present invention relates to a gas barrier film for the applications requiring high gas barrier properties such as food and medical wrapping applications and solar battery, electronic paper, organic electroluminescence (EL) display, and other electronic component applications. The present invention also relates to a method for producing such gas barrier film.

Background Art

Transparent gas barrier films prepared by using an inorganic substance (including inorganic oxide) such as aluminum oxide, silicon oxide, or magnesium oxide, and forming a vapor deposition layer of such inorganic substance on the surface of a polymer film substrate by vapor deposition, sputtering, ion plating, or other physical vapor deposition (PVD), or plasma chemical vapor deposition, thermochemical vapor deposition, photochemical vapor deposition, or other chemical vapor deposition (CVD) have been used for food and medical wrapping materials requiring blockage of gases such as steam and oxygen as well as components of electronic device such as electronic paper and solar battery. In the application such as electronic paper, organic thin film solar battery, and the like, a gas barrier property as high as up to $1.0 \times 10^{-3}$ g/(m$^2$.24hr.atm) in terms of water vapor transmission rate is required while a water vapor transmission rate of up to $1.0 \times 10^{-5}$ g/m$^2$.24hr.atm is required in applications such as organic EL display and flexible display.

As an attempt to satisfy the need for the high steam barrier property as described above, there has been proposed a multi-layer gas barrier film prepared by alternately disposing an organic layer and an inorganic layer where defect generation has been prevented by gap-filling (Patent Document 1). Also proposed is a gas barrier film wherein an inorganic layer is formed on a polymer film substrate having its surface smoothened for the purpose of reducing the defects (Patent Documents 2 and 3).

Also proposed are a laminate sheet prepared by forming a ZnO-SiO$_2$-based film on a film substrate by sputtering using a target containing ZnO and SiO$_2$ as the main components (Patent Document 4) and a gas barrier sheet prepared by forming a Si-O-Zn film having a Si:O:Zn (atom number ratio) in the range of 100 : 200 to 500 : 2 to 100 on the substrate by ion plating.

However, mere formation of an inorganic film on the film substrate was insufficient in improving the softness, and such constitution was occasionally associated with the problem of film breakage upon bending of the film as well as unduly high reflectivity due to difference in the refractive index with the film substrate, for example, in the case of silicon nitride with high refractive index.

Prior Art Document

Patent Document

Patent Document 1: Japanese Unexamined Patent Publication (Kokai) No. 2005-324406 (Claims)
Patent Document 2: Japanese Unexamined Patent Publication (Kokai) No. 2002-113826 (Claims)
Patent Document 3: Japanese Unexamined Patent Publication (Kokai) No. 2008-246893 (Claims)
Patent Document 4: Japanese Unexamined Patent Publication (Kokai) No. 2013-47363 (Claims)
Patent Document 5: Japanese Unexamined Patent Publication (Kokai) No. 2009-24255 (Claims)

Summary of the Invention

Problems to Be Solved by the Invention

However, the method of alternately disposing many organic and inorganic layers has been associated with the risk of heat-induced damages of the polymer film substrate caused by plasma radiation heat generated in the course of laminating several dozen layers resulting in the warping by thermal yield and poor workability in the post-processing, poor softness of the gas barrier film which resulted in the inferior gas barrier property with less resistance to bending.

In the case of the method using the substrate on which the gas barrier layer is formed in combination with a smooth substrate or a substrate having an anchor coat provided the purpose of surface smoothing, realization of a high gas barrier property of up to $1.0 \times 10^{-6}$ g/m$^2$.24hr.atm has been difficult since the property of the gas barrier layer formed is not improved despite the improvement in the reproducibility of the gas barrier property by the prevention of pinhole and crack generation.

In addition, mere formation of an inorganic film on the film substrate was insufficient in improving the softness, and such constitution was occasionally associated with the problem of film breakage upon bending of the film as well as unduly high reflectivity due to difference in the refractive index with the film substrate, for example, in the case of silicon nitride with high refractive index.

In view of the situation of the prior art as described above, an object of the present invention is to provide a gas barrier film which is less likely to undergo loss of gas barrier property when it is bent and which exhibits high transparency and high gas barrier property.

Means for Solving the Problems

In order to obviate the problems as described above, the present invention adopts the means as described below.

[1] A gas barrier film comprising a polymer film substrate and a gas barrier layer containing at least zinc oxide and silicon dioxide on at least one surface of the polymer film substrate, wherein the gas barrier layer satisfies at least one of the following [I] to [III]:

[I] with regard to X-ray absorption near edge structure (XANES) spectrum at K absorption edge of zinc, the value of (spectrum intensity at 9664.0 eV) / (spectrum intensity at 9668.0 eV) is in the range of 0.910 to 1.000;

[II] the value obtained by dividing atomic concentration of zinc with atomic concentration of silicon is in the range of 0.1 to 1.5, and structural density index represented by the following equation:

$$\text{structural density index} = \{\text{density of the gas barrier layer obtained by X-ray reflectometry (XRR)}\} / \{(\text{theoretical density calculated from compositional ratio determined by X-ray photoelectron spectroscopy (XPS)}\} \text{ is 1.20 to 1.40; and}$$

[III] when peak in the wave number range of 900 to 1,100 cm$^{-1}$ measured in FT-IR measurement is subjected to peak separation into the wave number of 920 cm$^{-1}$ and the wave number of 1,080 cm$^{-1}$, the value of ratio (A/B) of integrated intensity of the spectrum having its peak at 920 cm$^{-1}$ (A) to integrated intensity of the spectrum having its peak at 1, 080 cm$^{-1}$ (B) is at least 1.0 and up to 7.0.

[2] A gas barrier film according to the above [1] wherein, in radial distribution function obtained by Fourier transformation of the extended X-ray Absorption Fine Structure (EXAFS) spectrum at K absorption edge of zinc in the gas barrier layer, the value of (spectrum intensity at 0.28nm) / (spectrum intensity at 0.155 nm) is 0.08 to 0.20.

[3] A gas barrier film according to the above [1] or [2] wherein the gas barrier layer has a hardness of 0.8 to 1.8 GPa.

[4] A gas barrier film according to any one of [1] to [3] wherein the gas barrier layer has a density as measured by X-ray reflectometry of 1 to 7 g/cm$^3$.

[5] A gas barrier film according to any one of the above [1] to [4] wherein the gas barrier layer contains aluminum oxide.

[6] A gas barrier film according to any one of the above [1] to [5] wherein the film has an anchor coat layer between the polymer film substrate and the gas barrier layer.

[7] A gas barrier film according to the above [5] or [6] wherein the gas barrier layer has a zinc (Zn) atomic concentration of 1 to 35 atm%, a silicon (Si) atomic concentration of 5 to 25 atm%, an aluminum(Al) atomic concentration of 1 to 7 atm%, and an oxygen (O) atomic concentration of 50 to 70 atm% when measured by X-ray photoelectron spectroscopy.

[8] A method for producing a gas barrier film comprising a polymer film substrate and a gas barrier layer, containing at least zinc oxide and silicon dioxide on at least one surface of the polymer film substrate wherein, after adjusting the polymer film substrate surface to a temperature of 40 to 200°C, sputtering is conducted by using a target material containing zinc oxide and silicon dioxide wherein the value obtained by dividing atomic concentration of zinc with atomic concentration of silicon is in the range of 1.4 to 8.5 to form the gas barrier layer.

[9] A method for producing a gas barrier film comprising a polymer film substrate and a gas barrier layer containing at least zinc oxide and silicon dioxide on at least one surface of the polymer film substrate wherein sputtering is conducted under the pressure of oxygen-containing gas of less than 0.20 Pa to form the gas barrier layer.

[10] A method for producing a gas barrier film according to [9] wherein the polymer film substrate in the sputtering satisfies the following (1) and (2):

(1) temperature of the surface opposite to the surface where the gas barrier layer is formed is at least -20°C and up to 150°C, and
(2) (temperature of the surface where the gas barrier layer is formed) - (temperature of the surface opposite to the surface where the gas barrier layer is formed) ≤ 100 (°C).

[11] A method for producing a gas barrier film according to any one of the above [8] to [10] wherein the target material contains aluminum.
[12] A method for producing a gas barrier film according to any one of the above [8] to [11] wherein sputtering is conducted on the anchor coat layer of the substrate having the anchor coat layer.
[13] A method for producing a gas barrier film according to the above [11] or [12] wherein the target material has a zinc (Zn) atomic concentration of 3 to 37 atm%, a silicon (Si) atomic concentration of 5 to 20 atm%, an aluminum (Al) atomic concentration of 1 to 7 atm%, and an oxygen (0) atomic concentration of 50 to 70 atm%.

Advantageous Effect of the Invention

The present invention is capable of providing a gas barrier film which does not experience loss of gas barrier property upon bending, and which exhibits high transparency and high level gas barrier property.

Brief Description of the Drawings

[FIG. 1] FIG. 1 is a cross sectional view showing an embodiment of the gas barrier film of the present invention.
[FIG. 2] FIG. 2 is a cross sectional view showing another embodiment of the gas barrier film of the present invention.
[FIG. 3] FIG. 3 is a schematic view schematically showing an embodiment of a leaf-type sputtering apparatus used in producing the gas barrier film of the present invention.
[FIG. 4] FIG. 4 is a schematic view schematically showing an embodiment of the substrate holder surface of leaf-type sputtering apparatus used in producing the gas barrier film of the present invention.
[FIG. 5] FIG. 5 is a schematic view schematically showing an embodiment of the arrangement of the electrodes and heaters of leaf-type sputtering apparatus used in producing the gas barrier film of the present invention.
[FIG. 6] FIG. 6 is a schematic view schematically showing an embodiment of a winding-type sputtering apparatus used in producing the gas barrier film of the present invention.
[FIG. 7] FIG. 7 is a graph showing XANES spectrum at K edge of zinc for the standard substances and the Examples.

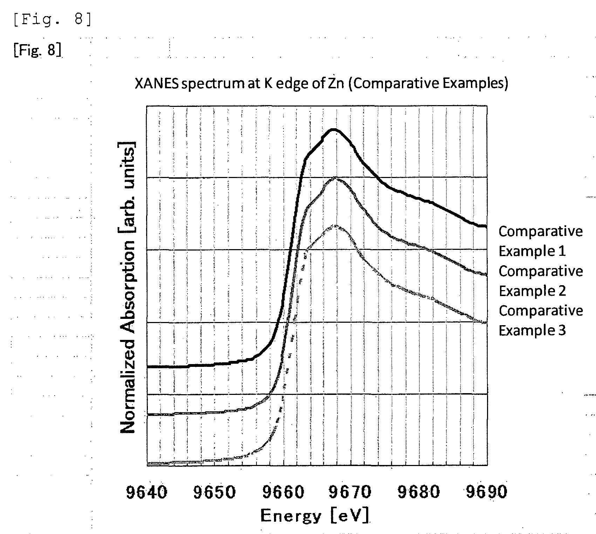

[FIG. 8] FIG. 8 is a graph showing XANES spectrum at K edge of zinc for the standard substances and the Comparative Examples.
[FIG. 9] FIG. 9 is a graph showing radial distribution function obtained from EXAFS spectrum at K edge of zinc for the standard substances and the Examples.

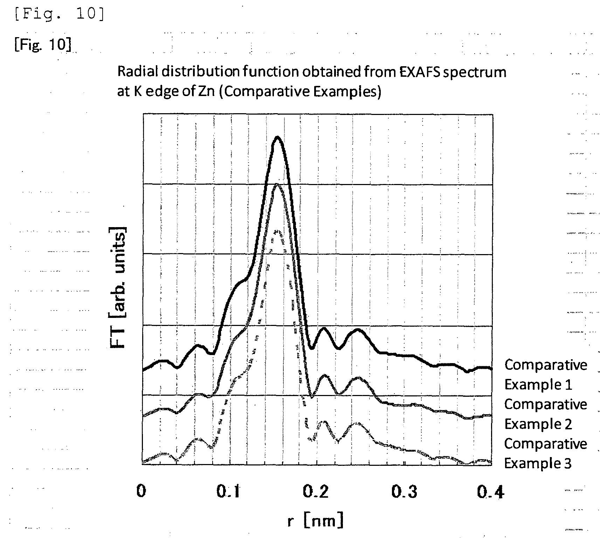

[FIG. 10] FIG. 10 is a graph showing radial distribution function obtained from EXAFS spectrum at K edge of zinc for the standard substances and the Comparative Examples.

Description of Preferred Embodiments

(Gas barrier film)

The inventors of the present invention made an intensive study to obtain a gas barrier film having a high transparency, high steam barrier property, and flexing endurance, and found that the problems as described above can be solved when the gas barrier film comprises a polymer film substrate and a gas barrier layer containing at least zinc oxide and silicon dioxide on at least one surface of the polymer film substrate, and the gas barrier layer satisfies at least one of the following [I] to [III]:

[I] with regard to X-ray absorption near edge structure (XANES) spectrum at K absorption edge of zinc, the value of (spectrum intensity at 9664.0 eV) / (spectrum intensity at 9668.0 eV) is in the range of 0.910 to 1.000;
[II] the value obtained by dividing atomic concentration of zinc with atomic concentration of silicon is in the range of 0.1 to 1.5, and structural density index represented by the following equation:

```
structural density index = {density of the gas barrier
layer obtained by X-ray reflectometry (XRR)} / {(theoretical
density calculated from compositional ratio determined by X-ray
photoelectron spectroscopy (XPS)} is 1.20 to 1.40; and
```

[III] when peak in the wave number range of 900 to 1,100 cm$^{-1}$ measured in FT-IR measurement is subjected to peak separation into the wave number of 920 cm$^{-1}$ and the wave number of 1,080 cm$^{-1}$, the value of ratio (A/B) of integrated intensity of the spectrum having its peak at 920 cm$^{-1}$ (A) to integrated intensity of the spectrum having its peak at 1,080 cm$^{-1}$ (B) is at least 1.0 and up to 7.0.

The use of the zinc oxide in the gas barrier layer is preferable due to its excellent gas barrier property and optical property, and the use of the silicon oxide is preferable due to its ability of forming an amorphous film and as well as excellent gas barrier property. Next, the [I] to [III] are described in detail. It is to be noted that the effects of the present invention are realized even if only one of the [I] to [III] is satisfied. However, two or more of the [I] to [III] are preferably satisfied in view of realizing higher effects.

(Gas barrier film having a gas barrier layer satisfying [I])

In the present invention, [I] means that, in X-ray absorption near edge structure (XANES) spectrum at K absorption edge of zinc, the value of (spectrum intensity at 9664.0 eV) / (spectrum intensity at 9668.0 eV) is preferably in the range of 0. 910 to 1.000. The structure of the gas barrier layer having such property is identified by X-ray absorption fine structure (XAFS) evaluation for the K absorption edge of zinc by the method as described below. XAFS is classified into X-ray absorption near edge structure (XANES) and extended X-ray absorption fine structure (EXAFS). XANES is the absorption near edge structure which appears in the narrow range of about 50 eV near the X-ray absorption edge of the sample. On the other hand, EXAFS is the absorption fine structure appearing in a wide range of approximately 100 eV to 1 keV on the high energy side than XANES. Information on valence and structure of the atom being observed is obtained from XANES, while information on local structure (type, valence, distance of atoms around the atom being observed) of the sample are mainly obtained from EXAFS.

The measurement by XAFS is conducted as described below, namely by generating X-ray from X-ray source, monochromatizing the X-ray by a monochromator, and focusing the X-ray by a focusing mirror; placing the sample on the X-ray path; and guiding the X-ray focused by the focusing mirror through the sample to measure the X-ray intensity before and after passing through the sample in an ion chamber. By this procedure, X-ray energy is scanned in the range of -500 eV to +1,200 eV using the target absorption edge for the standard, and absorbance is thereby calculated from the X-ray intensity before and after passing through the sample. The absorbance is then plotted in relation to the scanning energy to obtain the X-ray absorption spectrum.

For the resulting X-ray absorption spectrum, any 2 points, in the range of 50 to 300 eV are selected, and approximation by least square method is conducted by the equation of Victoreen, and background is removed by extrapolation from the absorption edge to the high energy side. Next, any 2 points in the range of 100 to 1,000 eV are selected, and standardization is conducted so that intensity of the curve depicted by approximating the center of oscillation of the EXAFS oscillation component with spline function is 1 in the energy area of the measured region to extract EXAFS oscillation component. The thus obtained EXAFS oscillation component is assigned with the weight of the cube of the wave number k, and finite Fourier transform is conducted in the range of 3 to 12 (angstrom$^{-1}$) to obtain radial distribution function around the zinc atom.

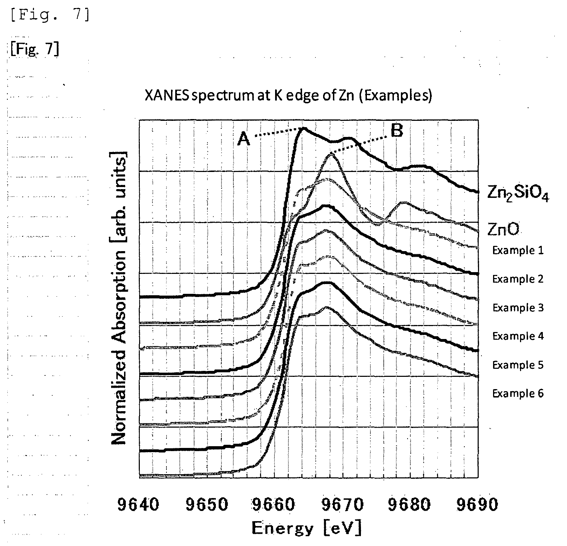

With regard to the XANES spectrum at K absorption edge of zinc of the gas barrier layer (FIG. 7), A part (spectrum intensity at 9664.0 eV) is from zinc silicate component, and B part (spectrum intensity at 9668.0 eV) is from zinc oxide component.

A larger value of (the spectrum intensity at 9664.0 eV) / (the spectrum intensity at 9668.0 eV) means that the gas barrier layer has a higher content of the zinc silicate component, while a smaller value of (the spectrum intensity at 9664.0 eV) / (the spectrum intensity at 9668.0 eV) means that the gas barrier layer has a higher content of the zinc oxide. The value of (the spectrum intensity at 9664.0 eV) / (the spectrum intensity at 9668.0 eV) is preferably 0.910 to 1.000. When this value is less than 0.910, proportion of the zinc silicate component in the gas barrier layer will be low and the low compactness may result in the failure of realizing the desired gas barrier property. On the other hand, when this value is in excess of 1.000, proportion of the zinc silicate component in the gas barrier layer will be high and the excessive compactness may invite crack generation. In view of the gas barrier property, this value is more preferably 0. 920 to 1.000, and still more preferably 0.920 to 0.960.

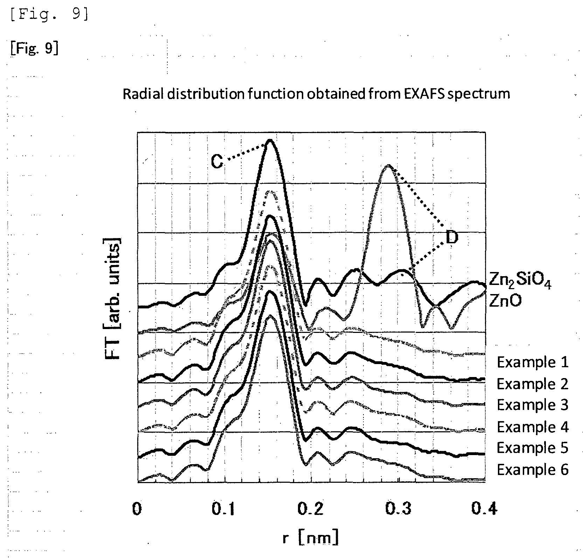

With regard to the radial distribution function (FIG. 9) obtained by EXAFS of the K absorption edge of zinc of the gas barrier layer, C part (the spectrum intensity at 0.155 nm) corresponds to Zn-0 nearest to ZnO, and D part (the spectrum intensity at 0.28 nm) corresponds to Zn-Zn or Zn-Si second or third nearest to ZnO.

The high value of (the spectrum intensity at 0.28 nm) / (spectrum intensity at 0.155 nm) means high ordering of the atoms second or third nearest to Zn. On the other hand the smaller value of (the spectrum intensity at 0.28 nm) / (the spectrum intensity at 0.155 nm) means low ordering of the atoms second or third nearest to Zn, and hence, low crystallinity. The value of (the spectrum intensity at 0.28 nm) / (the spectrum intensity at 0.155 nm) is preferably 0.08 to 0.20. When this value is less than 0.08, structural ordering in the layer is low, and this may result in the failure of realizing the desired gas barrier property. On the other hand, when this value is in excess of 0.20, the excessively high ordering may result in the susceptibility to crack generation. In view of the gas barrier property, this value is more preferably 0.09 to 0.20, still more preferably 0.09 to 0.15, and particularly preferably 0.12 to 0.14.

(Production method of a gas barrier film having a gas barrier layer satisfying [I])

The production method of the gas barrier film having a gas barrier layer satisfying [I] is a production method of a gas barrier film wherein a gas barrier layer containing at least zinc oxide and silicon dioxide is formed on at least one side of the polymer film substrate, wherein the gas barrier layer is formed by the method as described below.

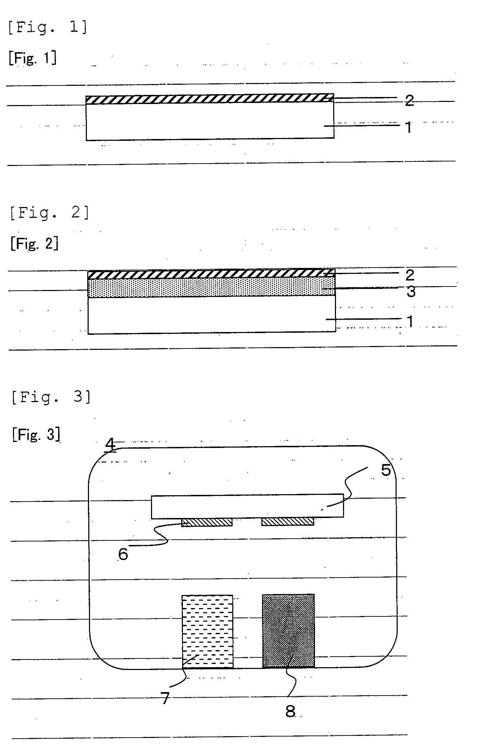

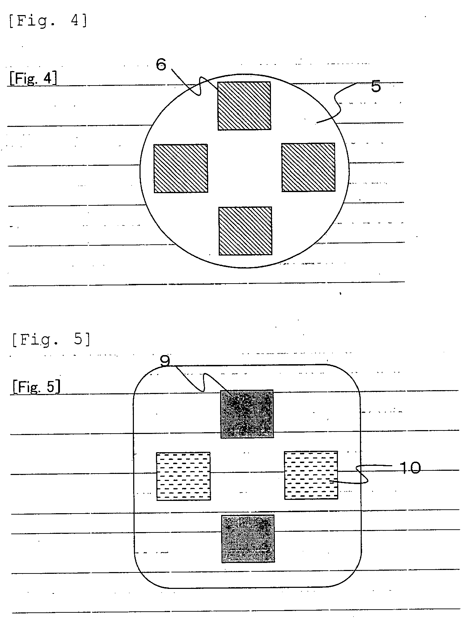

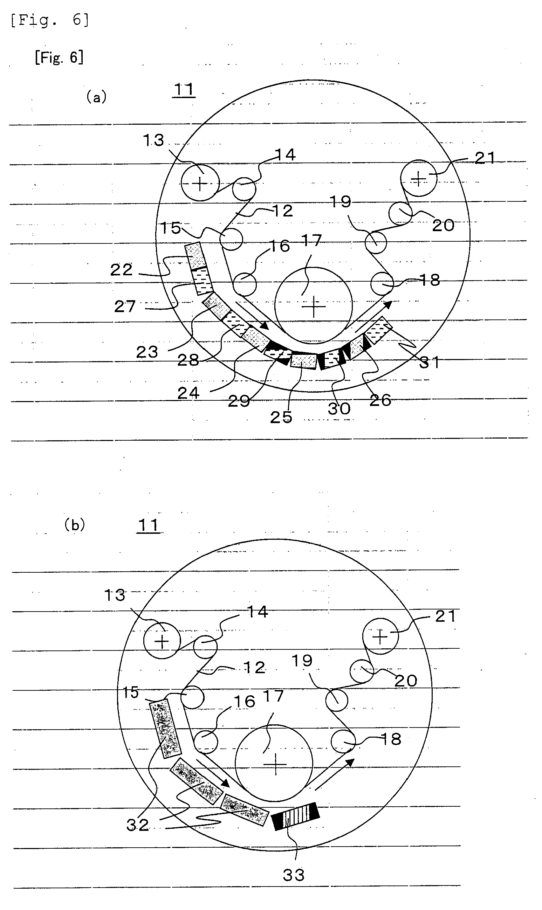

In the present invention, the gas barrier layer satisfying the [I] may be formed, for example, by sputtering, vapor deposition, ion plating, andCVD. Of these, the preferred is sputtering in view of the low cost, convenience, and realization of the desired properties of the layer. The method used for the sputtering may be leaf-system, roll-to-roll system, or any other method. FIGS. 3 to 5 show embodiments of the sputtering apparatus when the sputtering is conducted by leaf-system, and FIGS. 6(a) and 6(b) show embodiments of the sputtering apparatus when the sputtering is conducted by roll-to-roll system.

Formation of the gas barrier layer of the present invention satisfying the [I] by sputtering may be conducted by using a target material at least containing zinc oxide and silicon dioxide (with the ratio obtained by dividing the zinc atomic concentration by the silicon atomic concentration of 1. 4 to 8.5), and conducting the sputtering after heating the surface of the polymer film substrate to a temperature of 40 to 200°C. (The zinc atomic concentration divided by the silicon atomic concentration may be hereinafter also referred to as the "zinc/silicon ratio".) Use of such conditions enables uniform dispersion of the particles of the inorganic material forming the gas barrier layer on the surface of the polymer film substrate in the sputtering, and this facilitates higher compactness of the gas barrier layer, to thereby enable formation of the gas barrier layer having the gas barrier property that could not have been attained by similar constitution. In the following description, the uniform dispersion of the particles of the inorganic material forming the gas barrier layer on the surface of the polymer film substrate in the course of the sputtering may be abbreviated as the "surface dispersion of the particles". The conditions used are hereinafter described in further detail.

As described above, the zinc/silicon ratio of the target material is preferably 1.4 to 8.5. When the zinc/silicon ratio is less than 1.4, the resulting gas barrier layer may have an insufficient softness due to the smaller amount of the soft metal zinc in the gas barrier layer. In view of such situation, the zinc/silicon ratio is more preferably at least 1.5. On the other hand, when the zinc/silicon ratio is in excess of 8.5, the resulting gas barrier layer may become more susceptible to crack generation due to difficulty of taking the amorphous structure. In view of such situation, the zinc/silicon ratio is more preferably up to 6.5.

The sputtering is preferably conducted after adjusting the surface temperature of the polymer film substrate to the range of 40 to 200°C since surface dispersion of the particles would be improved and this facilitates improvement in the compactness of the gas barrier layer. It is to be noted that "the sputtering after adjusting the surface temperature of the polymer film substrate to the range of 40 to 200°C" means that the surface temperature of the polymer film substrate is adjusted to the range of 40 to 200°C before conducting the sputtering. More specifically, this temperature does not include the increase in the temperature caused by the collision of the inorganic material particles to the polymer film substrate surface in the course of the sputtering which also results in the temperature increase of the polymer film substrate surface. When the temperature of the polymer film substrate surface is less than 40°C, the effect of the surface dispersion of the particles will be insufficient, and the resulting gas barrier property may be insufficient. On the other hand, when the temperature of the polymer film substrate surface is in excess of 200°C, the polymer film substrate may experience melt deformation, and in such a case, use of the polymer film substrate as a gas barrier film may no longer be possible. The surface temperature of the polymer film substrate before the film formation is preferably adjusted to 100 to 180°C, and more preferably to the range of 100 to 150°C in view of regulating the gas barrier property and suppressing the thermal yield of the film.

The method used for adjusting the temperature of the surface of the polymer film substrate include heating of the polymer film substrate from the front side with an IR heater, and heating of the polymer film substrate from the rear side by using the main roll (the roll shown by the reference numeral 17 in FIGS. 6 (a) and (b)) supporting the polymer film substrate in the sputtering, namely, by heating the main roll which is normally used as a cooling drum in the sputtering. The method used for the heating is not limited to such methods as long as heating to such temperature range is possible.

However, the preferred is the heating of the polymer film substrate from the front side by the IR heater in view of the efficient heating of the front side of the polymer film substrate. When the polymer film is heated from the front side by the IR heater, the sputtering target and the IR heater are preferably arranged in alternate manner as shown in FIG. 6 (a) in view of realizing the uniform surface temperature of the polymer film substrate and efficiently heating the sputtering particles flying to the surface. In addition, when the polymer film is heated from the front side by an IR heater, the polymer film substrate is preferably cooled from the rear side in view of suppressing the thermal yield of the film.

As described above, in the production method of the gas barrier film of the present invention, the gas barrier film is preferably formed by adjusting the surface temperature of the polymer film substrate to the range of 40 to 200°C and by using a target material having a zinc/silicon ratio of 1.4 to 8.5, the gas barrier layer formed in this process preferably has a zinc/silicon ratio of 0.1 to 1.5. When the zinc/silicon ratio of the gas barrier layer is in excess of 1.5, the gas barrier layer may become susceptible to breakage due to the crystallization of the component constituting the layer with higher risk of crack generation. When the zinc/silicon ratio of the gas barrier layer is less than 0.1, zinc atom contributing for the softness of the gas barrier layer will be reduced and the gas barrier layer may become susceptible to breakage. The large difference as described above in the zinc/silicon ratio between the target material and the resulting gas barrier layer is caused by the accelerated escape of the zinc atom with high steam pressure by the heating of the polymer film substrate surface. In view of the softness and the gas barrier property of the gas barrier film, the zinc/silicon ratio of the gas barrier layer is more preferably 0.3 to 1.2.

With regard to the X-ray absorption near edge structure (XANES) spectrum at K absorption edge of zinc in the gas barrier layer, when the value of (the spectrum intensity at 9664.0 eV) / (the spectrum intensity at 9668. 0 eV) is less than 0.910, this value can be increased by increasing the surface temperature of the polymer film substrate by increasing the output of the IR heater, or by reducing the distance between the sputtering target and the polymer film substrate to thereby improve the surface dispersion of the particles. When this value is in excess of 1.000, this value may be reduced by using a sputtering target having a reduced zinc/silicon ratio, or by reducing the surface temperature of the polymer film substrate by reducing the output of the IR heater.

(Gas barrier film having a gas barrier layer satisfying [II])

In the present invention, [II] means that the proportion determined by dividing the zinc atomic concentration by the silicon atomic concentration is 0.1 to 1.5, and the structural density index represented by the following equation is 1.20 to 1.40.

$$\text{Structural density index} = \{\text{density of the gas barrier layer determined by X-ray reflectometry (XRR)}\} / \{\text{theoretical density calculated by the compositional ratio determined by X-ray photoelectron spectroscopy (XPS)}\}$$

The zinc/silicon ratio of the gas barrier layer is preferably 0.1 to 1.5. When the zinc/silicon ratio of the gas barrier layer is in excess of 1.5, the gas barrier layer may become more susceptible to breakage due to the crystallization of the components constituting the gas barrier layer and the resulting higher susceptibility of crack generation. When the zinc/silicon ratio of the gas barrier layer is less than 0.1, the gas barrier layer may become more susceptible to breakage since amount of the zinc atom contributing for the softness of the gas barrier layer is reduced in the gas barrier layer.

The structural density index is an index for evaluating compactness of the gas barrier layer, and it is determined by calculating theoretical density from the compositional ratio of the gas barrier layer determined by X-ray photoelectron spectroscopy (XPS), finding actual density by X-ray reflectometry (XRR), and determining the actual density/theoretical density by calculation. The theoretical density used is the volume occupied by 1 g of the compound in the thin film calculated by the following equation:

$$\text{Theoretical density } [g/cm^3] = \text{thin film 1 } [g] / (\text{volume } [cm^3] \text{ of the compound A in 1 g} + \text{volume } [cm^3] \text{ of the compound B in 1 g} + ... + \text{volume } [cm^3] \text{ of the compound Z in 1 g } [cm^3])$$

For example, when the compositional ratio of the gas barrier layer is constituted by the following three types of elements, the theoretical density may be calculated as described below by assuming complete oxide for all elements.

ZnO 61.0 [am%], actual density 5.60 [g/cm$^3$], molecular weight 81.4
SiO$_2$ 35.0 [am%], actual density 2.20 [g/cm$^3$], molecular weight 60.1
Al$_2$O$_3$ 4.0 [atm%], actual density 3.97 [g/cm$^3$], molecular weight 102.0

$$\text{Theoretical density [g/cm}^3\text{]} = 1 \text{ [g]} / \{\{61.0 \text{ [atm\%]} \times 81.4 / (61.0 \text{ [atm\%]} \times 81.4 + 35.0 \text{ [atm\%]} \times 60.1 + 4.0 \text{ [atm\%]} \times 102.0)\} + \{35.0 \text{ [atm\%]} \times 60.1 / (61.0 \text{ [atm\%]} \times 81.4 + 35.0 \text{ [atm\%]} \times 60.1 + 4.0 \text{ [atm\%]} \times 102.0)\} + \{4.0 \text{ [atm\%]} \times 102.0 / (61.0 \text{ [atm\%]} \times 81.4 + 35.0 \text{ [atm\%]} \times 60.1 + 4.0 \text{ [atm\%]} \times 102.0)\}\}$$

$$= 3.84 \text{ [g/cm}^3\text{]}$$

The high value of the structural density index obtained by the calculation as described above means that the gas barrier layer is more compact. On the other hand, the low value of the structural density index means that the gas barrier layer is not compact and that it may suffer from defects and cracks. The gas barrier layer of the gas barrier film of the present invention preferably has a structural density index of 1.20 to 1.40. When the structural density index is less than 1.20, it should be assumed that the gas barrier layer should have many gaps and defects, and it may not have a good gas barrier property. On the other hand, when the structural density index is in excess of 1.40, the resulting coordinate structure may become different from the desired coordinate structure and the intended good gas barrier property may not be realized. In view of the gas barrier property, the structural density index is more preferably in the range of 1.25 to 1.35, and still more preferably 1.30 to 1.35.

(Production method of the gas barrier film having a gas barrier layer satisfying [II])

The production method of the gas barrier film having a gas barrier layer satisfying [II] is a production method of a gas barrier film wherein a gas barrier layer containing at least zinc oxide and silicon dioxide is formed on at least one side of the polymer film substrate, wherein the gas barrier layer is formed by the method as described below.

In the present invention, the gas barrier layer satisfying [II] is produced by using a target material containing zinc oxide and silicon dioxide at the zinc/silicon ratio of 1.4 to 8.5, and by conducting the sputtering after heating the surface of the polymer film substrate to a temperature of 40 to 200°C to thereby form the gas barrier layer. Such conditions result in the improved surface dispersion of the particles, and hence, higher compactness of the gas barrier layer, and this realizes the high gas barrier property which had not been realized by similar constitution.

The target material used preferably has a zinc/silicon ratio of 1.4 to 8.5. When the zinc/silicon ratio is less than 1.4, the gas barrier layer may suffer from insufficient softness upon formation of the gas barrier layer due to the reduced amount of the zinc which is the soft metal. In view of such situation, the zinc/silicon ratio is more preferably at least 1.5. When the zinc/silicon ratio is in excess of 8.5, the gas barrier layer may suffer from crack generation upon formation of the gas barrier layer due to its difficulty of taking amorphous structure. In view of such situation, the zinc/silicon ratio is more preferably up to 6.5.

The sputtering is preferably conducted after adjusting the surface temperature of the polymer film substrate to the range of 40 to 200°C since surface dispersion of the particles would be improved and this facilitates improvement in the compactness of the gas barrier layer. It is to be noted that, as in the case of [I], "the sputtering after adjusting the surface temperature of the polymer film substrate to the range of 40 to 200°C" means that the surface temperature of the polymer film substrate is adjusted to the range of 40 to 200°C before conducting the sputtering. More specifically, this temperature does not include the increase in the temperature caused by the collision of the inorganic material particles to the polymer film substrate surface in the course of the sputtering which also results in the temperature increase of the polymer film substrate surface. When the temperature of the polymer film substrate surface is less than 40°C, the effect of the surface dispersion of the particles will be insufficient, and the resulting gas barrier property may be insufficient. On the other hand, when the temperature of the polymer film substrate surface is in excess of 200°C, the polymer film substrate may experience melt deformation, and in such a case, use of the polymer film substrate as a gas barrier film may no longer be possible.

The method used for adjusting the temperature of the surface of the polymer film substrate include heating of the polymer film substrate from the front side with an IR heater, and heating of the polymer film substrate from the rear side by using the main roll (the roll shown by the reference numeral 17 in FIG. 6(b)) supporting the polymer film substrate in the sputtering, namely, by heating the main roll which is normally used as a cooling drum in the sputtering. The method used for the heating is not limited to such methods as long as heating to such temperature range is possible. However, the preferred is the heating of the polymer film substrate from the front side by the IR heater in view of the efficient heating of the front side of the polymer film substrate.

As described above, in the production method of the gas barrier film of the present invention, the gas barrier film is preferably formed by sputtering by adjusting the surface temperature of the polymer film substrate to the range of 40 to 200°C and by using a target material having a zinc/silicon ratio of 1.4 to 8.5, and the gas barrier layer formed in this process preferably has a zinc/silicon ratio of 0.1 to 1.5. When the zinc/silicon ratio of the gas barrier layer is in excess of 1.5, the gas barrier layer may become susceptible to breakage due to the crystallization of the component constituting the layer with higher risk of crack generation. When the zinc/silicon ratio of the gas barrier layer is less than 0.1, zinc atom contributing for the softness of the gas barrier layer will be reduced and the gas barrier layer may become susceptible to breakage. The large difference as described above in the zinc/silicon ratio between the target material and the resulting gas barrier layer is caused by the accelerated escape of the zinc atom with high steam pressure by the heating of the polymer film substrate surface. In view of the softness and the gas barrier property of the gas barrier film, the zinc/silicon ratio of the gas barrier layer is more preferably 0.3 to 1.2.

The compositional ratio of the target material and the gas barrier layer may be measured by using X-ray photoelectron spectroscopy (hereinafter also referred to as XPS) as described below. The outermost layers of the target material and the gas barrier layer are generally excessively oxidized and they are different from the interior compositional ratio, and accordingly, 5 nm of the outermost layer is removed by etching (sputter etching using argon ion) as a pretreatment of the XPS analysis. The compositional analysis is then conducted, and the thus obtained atomic concentration is used for the atomic concentration of the present invention.

With regard to the compositional ratio of the target material, the zinc (Zn) atomic concentration is preferably in the range of 3 to 37 atm%, the silicon (Si) atomic concentration is preferably in the range of 5 to 20 atm%, the aluminum (Al) atomic concentration is preferably in the range of 1 to 7 atm%, and the oxygen (O) atomic concentration is preferably in the range of 50 to 70 am%. When the zinc atomic concentration is less than 3 atm% or the silicon atomic concentration is in excess of 20 atm%, proportion of the zinc atom contributing for the softness of the gas barrier layer will be reduced, and the resulting gas barrier film having the gas barrier layer formed thereon may suffer from insufficient softness. In view of such situation, the zinc atomic concentration is more preferably at least 5 am%. When the zinc atomic concentration is in excess of 37 atm% or the silicon atomic concentration is less than 5 atm%, proportion of the silicon atom will be reduced and the resulting gas barrier layer is likely to be a crystalline film susceptible to crack generation. In view of such situation, the zinc atomic concentration is more preferably up to 36.5 am%. In view of the same situation, the silicon atomic concentration is more preferably at least 7 am%. When the aluminum atomic concentration is less than 1 atm%, electroconductivity of the target material will be impaired and DC sputtering may become unavailable. When the aluminum atomic concentration is in excess of 7 atm%, affinity between the zinc oxide and the silicon dioxide will be excessively high after the formation of the gas barrier layer, and this may invite high susceptibility to cracks upon application of heat and external stress. When the oxygen atomic concentration is less than 50 atm%, the resulting gas barrier layer is likely to suffer insufficient oxidation, and this may invite reduced light transparency. When the oxygen atomic concentration is in excess of 70 atm%, oxygen is likely to be excessively incorporated in the gas barrier layer, and this may result in the increased gaps and defects with the loss of gas barrier property.

(Gas barrier film having a gas barrier layer satisfying [III])

In the present invention, [III] means that, when peaks in the wave number range of 900 to 1,100 $cm^{-1}$ measured in FT-IR measurement are subjected to peak separation into the wave number of 920 $cm^{-1}$ and the wave number of 1,080 $cm^{-1}$, value of ratio (A/B) of the integrated intensity of the spectrum having its peak at 920 $cm^{-1}$ (A) to the integrated intensity of the spectrum having its peak at 1.080 $cm^{-1}$ (B) is at least 1.0 and up to 7.0.

Since the gas barrier layer of the present invention contains zinc oxide and silicon dioxide, when the FT-IR is measured by the method as described below, absorption spectrum having peak in the wave number range of 900 to 1,100 $cm^{-1}$ will be obtained due to the zinc oxide, the silicon dioxide, and complex compounds thereof. When such peak in the wave number range of 900 to 1,100 $cm^{-1}$ is separated into the peak of 920 $cm^{-1}$ corresponding to the absorption by Zn-O-Si bond and the peak of 1,080 $cm^{-1}$ corresponding to the absorption by Si-O-Si bond, and the integrated intensity of each spectrum is compared, information on the ratio of the Si-O-Si bond to the Zn-O-Si bond in the gas barrier layer can be obtained. In the peak separation of the peak of the wave number 900 to 1,100 $cm^{-1}$, a straight line connecting 2 points (spectral values of 650 $cm^{-1}$ and 1,400 $cm^{-1}$) was depicted as a base line by using the software as described below, and 2 Gaussian functions were set. Only the position of the peak of one Gaussian function was used as fixed value, and the calculation was conducted. As a result of the calculation, the integrated intensity of the spectrum having its peak at 1,080 $cm^{-1}$ and the integrated intensity of the spectrum having its peak at 900 to 940 $cm^{-1}$ were regarded as the peak of 920 $cm^{-1}$ corresponding to the absorption of the Zn-O-Si bond, and the integrated intensity of the spectrum was respectively determined for the calculation of the ratio.

In the gas barrier layer satisfying the [III] of the present invention, the value of the ratio (A/B) of the integrated intensity of the spectrum having its peak at 920 $cm^{-1}$ (A) to the integrated intensity of the spectrum having its peak at 1,080 $cm^{-1}$ (B) is preferably at least 1.0 and up to 7.0. When this value of the ratio (A/B) of the integrated intensity of the spectrum having its peak at 920 $cm^{-1}$ (A) to the integrated intensity of the spectrum having its peak at 1, 080 $cm^{-1}$ (B) is less than 1.0, proportion of the Si-O-Si bond will be increased, and the resulting gas barrier layer may become less soft and more susceptible to cracking. When the value of the ratio (A/B) of the integrated intensity of the spectrum having its peak at 920 $cm^{-1}$ (A) to the integrated intensity of the spectrum having its peak at 1,080 $cm^{-1}$ (B) is in excess of 7.0, proportion of the Si-O-Si bond will be reduced, and hence, amorphousness will be reduced, and as a consequence, cracks may be easily formed with reduced barrier property. The value of the ratio (A/B) of the integrated intensity of the spectrum having its peak at 920 $cm^{-1}$ (A) to the integrated intensity of the spectrum having its peak at 1,080 $cm^{-1}$ (B) is more preferably at least 1.0 and up to 6.0, and still more preferably at least 1.0 and up to 5.0.

When absorption spectrum of a content other than the zinc oxide, the silicon dioxide, or the complex thereof having a peak at wave number of 900 to 1,100 $cm^{-1}$ is obtained in the gas barrier layer, the peak from such content is preferably separated and removed to obtain the value of the ratio (A/B) of the integrated intensity of the spectrum having its peak at 920 $cm^{-1}$ (A) to the integrated intensity of the spectrum having its peak at 1,080 $cm^{-1}$ (B). In this procedure, the peak separation is conducted by the same procedure as described above, and when 3 or more Gaussian functions are set (the spectrum having at least 3 peaks at 900 to 1,100 $cm^{-1}$), 920 $cm^{-1}$ and 1, 080 $cm^{-1}$ are used as the fixed value of the peak position of the Gaussian function to conduct the calculation of the respective integrated intensity.

(Production method of the gas barrier film having a gas barrier layer satisfying [III])

The production method of the gas barrier film having a gas barrier layer satisfying [III] is a production method of a gas barrier film wherein a gas barrier layer containing at least zinc oxide and silicon dioxide is formed on at least one side of the polymer film substrate, wherein the gas barrier layer is formed by the method as described below.

In other words, the production method is the one including the step wherein the sputtering is conducted by regulating the pressure of the gas including the oxygen to less than 0.20 Pa to thereby form the gas barrier layer. When the sputtering is conducted by using an oxygen-free gas (for example, by using only Ar gas), the gas barrier layer exhibits frequent oxygen deficiency with the difficulty of Si-O-Si bond and Zn-O-Si bond formation. Furthermore, the gas barrier layer may become a black-colored film with low light transparency. When the sputtering is conducted at the gas pressure of at least 0.20 Pa, the value of the ratio (A/B) of the integrated intensity of the spectrum having its peak at 920 $cm^{-1}$ (A) to the integrated intensity of the spectrum having its peak at 1,080 $cm^{-1}$ (B) may become in excess of 7 and this may result in the reduced Si-O-Si bond.

In the production method of the gas barrier film of the present invention, the polymer film substrate in the sputtering preferably satisfies the following (1) and (2):

(1) temperature of the surface opposite to the surface where the gas barrier layer is formed is at least -20°C and up to 150°C; and
(2) (temperature of the surface on which the gas barrier layer is formed) - (temperature of the surface opposite to the surface where the gas barrier layer is formed) $\leq$ 100 (°C). It is to be noted that "in the sputtering" means "during the sputtering", and in other words, surface temperature of the polymer film substrate increases in the sputtering by the collision of the inorganic material particles to the polymer film substrate, and this temperature includes the temperature increase attributable to such particle collision.

When (the temperature of the surface where the gas barrier layer is formed) - (the temperature of the surface opposite to the surface where the gas barrier layer is formed) is in excess of 100°C in the sputtering, difference in the thermal contraction between opposite surfaces of the polymer film substrate would be increased to invite curling and thermal yield. The temperature of the surface of the polymer film substrate opposite to the surface where the gas barrier layer is formed is preferably at least -20°C and up to 150°C. When the temperature of the surface opposite to the surface where the gas barrier layer is formed is at least -20°C, the value of the ratio (A/B) of the integrated intensity of the spectrum having its peak at 920 $cm^{-1}$ (A) to the integrated intensity of the spectrum having its peak at 1,080 $cm^{-1}$ (B) would be up to 7.0, and this is preferable. When the temperature of the surface of the polymer film substrate opposite to the surface where the gas barrier layer is formed is up to 150°C, the value of the ratio (A/B) of the integrated intensity of the spectrum having its peak at 920 $cm^{-1}$ (A) to the integrated intensity of the spectrum having its peak at 1, 080 $cm^{-1}$ (B) would also be at least 1.0, and this is preferable.

Generally, temperature of the surface where the gas barrier layer is formed by sputtering is higher than the temperature of the surface opposite to the surface where the gas barrier layer is formed. However, if (the temperature of the surface opposite to the surface where the gas barrier layer is formed) is at least -20°C and up to 150°C, and (the temperature of the surface where the gas barrier layer is formed) - (the temperature of the surface opposite to the surface where the gas barrier layer is formed) $\leq$ 100 (°C), the film breakage by the thermal yield of the polymer film substrate will be avoided, and such conditions are preferable.

The measurement of the temperature of both surfaces of the polymer film substrate may be conducted by using known techniques such as radiation thermometer, thermocouple, and the like. Preferably, the temperature is measured by adhering a thermocouple to the center on the surface of the polymer film substrate by using a heat-resistant tape with no exposure of the its metal part to thereby obtain thermohysteresis in the course of sputtering.

(Hardness of the gas barrier layer)

Hardness of the gas barrier layer can be measured by nanoindentation method (continuous stiffness measurement). The nanoindentation method is a method wherein an indenter is minutely vibrated in the indentation test, response amplitude and phase difference in response to the vibration are obtained as a function of time, and initial gradient upon removal of the indenter is continuously calculated in response to continuous change of the indentation depth. The gas barrier layer of the present invention preferably has a hardness of 0.8 to 1.8 GPa. When the hardness is less than 0.8 GPa, the excessively soft gas barrier layer may result in the risk of scratches. On the other hand, when the hardness is in excess of 1.8 GPa, the hard gas barrier layer may result in the failure of realizing the desired flexing endurance. In view of scratch resistance and flexing endurance, the hardness is more preferably in the range of 0.85 to 1.5 GPa, and still more preferably 0.85 to 1.1 GPa.

(Thickness of the gas barrier layer)

The thickness of the gas barrier layer is preferably 50 to 300 nm, and more preferably 100 to 200 nm. When the thickness of the gas barrier layer is less than 50 nm, the gas barrier property may become insufficient in some parts. On the other hand, the thickness in excess of 300 nm invites increase in the stress remaining in the layer, which may invite higher risk of crack generation in the gas barrier layer by the bending or exterior impact and loss of gas barrier property.

(Components other than the zinc oxide and the silicon dioxide in the gas barrier layer)

The gas barrier layer may contain inorganic compounds other than the zinc oxide and the silicon dioxide as long as these components are present. Exemplary additional inorganic compounds include oxide, nitride, sulfide, and the like of elements such as zinc, silicon, aluminum, titanium, tin, indium, niobium, tantalum, and zirconium, and mixtures thereof. In view of the gas barrier property, the preferred is inclusion of aluminum oxide, tin oxide, indium oxide, and silicon nitride, and the more preferred is inclusion of aluminum oxide.

(Density of the gas barrier layer)

Density of the thus formed gas barrier layer may be measured by X-ray reflectometry (XRR). XRR is a method wherein X-ray intensity profile of the X-ray reflected from the sample surface is measured after irradiating the X ray at an extremely shallow angle (approximately 0 to 5°) to the sample surface so that the X-ray is reflected in mirror direction to the incident angle. The profile obtained by this measurement is optimized by analytical simulation to determine the sample thickness as well as the density and coarseness of the layer. The density of the gas barrier layer measured by XRR is preferably 1 to 7 $g/cm^3$. When the density is less than 1 $g/cm^3$, the resulting gas barrier layer may have an insufficient compactness, and the gas barrier property may be insufficient. On the other hand, when the density of the gas barrier layer is in excess of 7 $g/cm^3$, the gas barrier layer is likely to be hard, and the gas barrier layer is likely to be cracked. In view of the gas barrier property and the flexing endurance, the gas barrier layer may preferably have a density of 2 to 7 $g/cm^3$, and more preferably, 2 to 5 $g/cm^3$.

(Compositional ratio of the gas barrier layer)

The compositional ratio of the gas barrier layer can be measured by X-ray photoelectron spectroscopy (XPS) as will be described below. Generally, the outermost surface of the gas barrier layer is excessively oxidized, and the compositional ratio would be different from that in the interior of the gas barrier layer. Accordingly, about 5 nm of the outermost layer is removed by etching by sputtering using argon ion as a pretreatment of the analysis by XPS, and the compositional analysis is conducted. The thus obtained atomic concentration is used for the atomic concentration in the present invention.

Preferably, the gas barrier layer has a compositional ratio with a zinc (Zn) atomic concentration of 1 to 35 atm%, a silicon (Si) atomic concentration of 5 to 25 atm%, an aluminum (Al) atomic concentration of 1 to 7 atm%, and an oxygen (0) atomic concentration of 50 to 70 atm%.

When the zinc atomic concentration is less than 1 atm% or the silicon atomic concentration is in excess of 25 atm%, proportion of the zinc atom contributing for the softness of the gas barrier layer will be reduced, and the softness of the gas barrier film may become reduced. In view of this, the zinc atomic concentration is preferably at least 3 atm%. When the zinc atomic concentration is in excess of 35 atm% or the silicon atomic concentration is less than 5 atm%, proportion of the silicon atom will be reduced and the gas barrier layer is likely to be a crystalline layer, namely, the one with a higher risk of cracks. In view of such situation, the silicon atomic concentration is preferably at least 7 atm%. When the aluminum atomic concentration is less than 1 atm%, affinity between the zinc oxide and the silicon dioxide will be lost, and the gas barrier layer suffers from higher risk of gaps and defects. In addition, when the aluminum atomic concentration is higher than 7 atm%, affinity between the zinc oxide and the silicon dioxide will be excessively high, and this may result in the increased risk of crack generation under heat or environmental stress. When the oxygen atomic concentration is less than 50 atm%, oxidation of the zinc, silicon, aluminum will be insufficient, and this may result in the reduced light transparency. When the oxygen atomic concentration is in excess of 70 atm%, excessive intake of the oxygen results in the increased gaps and defects, and this may result in the reduced gas barrier property.

(Polymer film substrate)

The polymer film substrate used in the present invention is not particularly limited as long as it is a film containing an organic polymer compound. Examples include films containing a polyolefin such as polyethylene or polypropylene, a polyester such as polyethylene terephthalate or polyethylene naphthalate, a polyamide, a polycarbonate, a polystyrene, polyvinyl alcohol, saponified ethylene vinyl acetate copolymer, polyacrylonitrile, polyacetal, or other polymers. Of these, the preferred is a film containing a polyethylene terephthalate. The polymer constituting the polymer film substrate may be either a homopolymer or a copolymer, and also, it may be either a single polymer or a blend of two or more polymers.

The polymer film substrate used may also be a monolayer film, a film comprising 2 or more layers produced, for example, by co-extrusion, or a monoaxially or biaxially stretched film. In order to improve the adhesion, the surface of the polymer film substrate on the side where a gas barrier layer is formed may be pretreated, for example, by corona treatment, ion bombardment, solvent treatment, surface roughening, or formation of an anchor coat layer comprising an organic substance, an inorganic substance, or a mixture thereof. In addition, the surface of the polymer film substrate opposite to the side where a gas barrier layer is formed may have a coating layer of an organic compound, an inorganic compound, or a mixture thereof in order to improve slidability in the winding of the film and reduce the friction caused between the polymer film substrate and the gas barrier layer in the winding of the film after the formation of the gas barrier layer. While the polymer film substrate used in the present invention is not particularly limited for its thickness, the thickness is preferably up to 500 $\mu$m in view of realizing softness of the gas barrier film, and more preferably at least 5 $\mu$m in view of reliably providing tensile and impact strength. In view of the film processing and handling, the thickness is still more preferably 10 $\mu$m to 200 $\mu$m.

(Anchor coat layer)

As shown in FIG. 2, an anchor coat layer is preferably formed on the surface of the polymer film substrate used in the present invention in order to improve the adhesion between the polymer film substrate and the vapor deposition layer. In view of facilitating surface dispersion of the sputtering particles flying to the anchor coat layer in the sputtering, the anchor coat layer may preferably have a pencil hardness of at least H and up to 3H. Pencil hardness is a grade of (softest) 10B to B, HB, F, H to 9H (hardest). When the anchor coat layer is softer than H, mixing is likely to take place upon hitting by sputtering particles to detract from sufficient surface dispersion properties, and there would be the case wherein formation of a compact gas barrier layer would be difficult. On the other hand, an anchor coat layer harder than 3H may have a negative influence on the flexing endurance of the gas barrier film, and the gas barrier layer will be more susceptible to crack generation.

When an anchor coat layer is present between the polymer film and the gas barrier layer of the resulting gas barrier film, the gas barrier layer will have a higher flatness, and hence, higher gas barrier property compared to the gas barrier film wherein the gas barrier layer is directly formed on the polymer film substrate. The gas barrier film will also have a higher softness compared to the case where the gas barrier layer is directly formed on the polymer film substrate.

Exemplary materials used for the anchor coat layer include polyester resin, isocyanate resin, urethane resin, acrylic resin, ethylene vinyl alcohol resin, vinyl modified resin, epoxy resin, modified styrene resin, modified silicone resin, and alkyl titanate, which may be used alone or in combination of two or more. The material used for the anchor coat layer of the present invention is preferably a two-part curing resin comprising a main agent and a curing agent in view of the solvent resistance, and more preferably, use of a polyester resin, a urethane resin, or an acrylic resin for the main agent is preferable in view of the gas barrier property and the water resistance. The curing agent is not particularly limited as long as it is used within the extent not adversely affecting the properties such as gas barrier property and transparency, and exemplary curing agents include common curing agents such as isocyanate and epoxy curing agents.

These anchor coat layer may also contain other known additives.

The anchor coat layer used in the present invention may preferably have a thickness of 0. 3 to 10 μm. When the thickness of the layer is less than 0.3 μm, the layer will reflect the surface irregularities of the polymer film substrate 1, and the gas barrier layer may suffer from unduly high surface roughness, and hence, result in the reduced gas barrier property. When the thickness of the layer is in excess of 10 μm, the stress remaining in the anchor coat layer will be increased, and this may result in the loss of gas barrier property due to the warping of the polymer film substrate 1 and crack generation in the gas barrier layer. Accordingly, the anchor coat layer may preferably have a thickness of 0.3 to 10 μm, and in view of reliably realizing the flexibility, the thickness is more preferably 1 to 3 μm.

Formation of the anchor coat layer on the surface of the polymer film substrate may be conducted, for example, by a method comprising the steps of preparing a coating composition by adding a solvent, a diluent, and the like to the materials of the anchor coat layer, applying the coating composition to the polymer film substrate by roll coating, gravure coating, knife coating, dip coating, spray coating, or the like to thereby form a coating, and removing the solvent, the diluent, and the like by drying to thereby form the anchor coat layer. Exemplary methods used for the drying of the coated film include hot roll-contacting method, hot medium (air, oil, etc.)-contacting method, infrared heating method, and microwave heating method. Of these, the preferred is gravure coating in view of its suitability for use in forming a layer having a thickness of 0.3 to 10 μm which is the preferable thickness of the anchor coat layer of the present invention.

The gas barrier film of the present invention has excellent gas barrier property for steam and the like, and accordingly, it is well adapted for use as a packaging material for food and drugs as well as electronic device member in thin TV, flexible display, solar battery, and the like.

Examples

[Evaluation methods]

The evaluations as described below were conducted. Unless otherwise noted, the number of measurement n is n = 1.

(1) X-ray absorption fine structure

Structure of the gas barrier layer was evaluated by X-ray absorption fine structure (XAFS). The evaluation was conducted by generating X-ray from X-ray source, monochromatizing the X-ray by a monochromator, and focusing the X-ray by a focusing mirror; placing the sample on the X-ray path; and guiding the X-ray focused by the focusing mirror through the sample to measure the X-ray intensity before and after passing through the sample in an ion chamber. By this procedure, X-ray energy was scanned in the range of -500 eV to +1,200 eV using the target absorption edge for the standard, and absorbance is thereby calculated from the X-ray intensity before and after passing through the sample. The absorbance was then plotted in relation to the scanning energy to obtain the X-ray absorption spectrum.

Analysis of the X-ray absorption spectrum was conducted by using a free software ATHENA (ver. 0.8.061) prepared by Chicago University. 2 points, namely, -30 eV and -300 eV were selected for the resulting X-ray absorption spectrum, and approximation by least square method was conducted by the equation of Victoreen, and background was removed by extrapolation from the absorption edge to the high energy side. Next, 2 points, namely, 150 eV and 1,000 eV were selected, and standardization was conducted so that intensity of the curve depicted by approximating the center of oscillation of the EXAFS oscillation component with spline function is 1 in the energy area of the measured region to extract EXAFS oscillation component. The thus obtained EXAFS oscillation component was assigned with the weight of the cube of the wave number k, and finite Fourier transform was conducted in the range of 3 to 12 (angstrom$^{-1}$) to obtain radial distribution function around the zinc atom.

The measurement conditions were as described below.

- experiment facility: High Energy Accelerator Research Organization, Photon Factory
- experiment station: BL9A
- spectroscope: Si(111)2 crystal spectroscope
- mirror: focusing mirror
- absorption edge: Zn K (9660.7eV) absorption edge
- detection method: permeametry
- sensor used: ion chamber

(2) Evaluation of the layer thickness and density

The thickness and the density of the gas barrier layer was evaluated by X-ray reflectometry (XRR) by irradiating the gas barrier layer formed on the polymer film substrate with an X-ray beam in oblique direction, and measuring dependency of the total X-ray reflection intensity to the incident X-ray intensity on the incident angle of the X-ray to the gas barrier layer surface to thereby obtain the X-ray intensity profile of the thus obtained reflected wave. Simulation fitting of the X-ray intensity profile was then conducted to determine the thickness and the density of each area.

The measurement conditions were as described below.

- apparatus: SmartLab manufactured by Rigaku
- software used for the analysis: GrobalFit manufactured by Rigaku
- sample size:30 mm x 40 mm
- wavelength of the incident X-ray: 0.1541 nm (CuK$\alpha_1$ ray)
- output: 45 kV, 30 mA
- incidence slit size: 0.05 mm x 5.0 mm
- receiving slit size: 0.05 mm x 20.0 mm
- range of the measurement ($\theta$): 0 to 4.0°
- step ($\theta$): 0.002°

(3) Compositional analysis

Compositional analysis of the gas barrier layer was conducted by X-ray photoelectron spectroscopy (XPS). More specifically, the outermost layer of about 5 nm was removed by etching by sputtering using argon ion, and ratio of the content of each element was thereafter measured. Presence of the compositional gradient in the gas barrier layer was not assumed, and the compositional ratio at this measurement point was used for the compositional ratio of the gas barrier layer.
The measurement conditions in the XPS were as described below.

- apparatus: ESCA 5800 (manufactured by ULVAC-PHI, Inc.)
- excited X-ray: monochromatic AlK$\alpha$
- X-ray output: 300 W
- X-ray diameter: 800 $\mu$m
- photoelectron escaping angle: 45°
- Ar ion etching: 2.0 kV, 10 mPa

(4) Measurement of water vapor transmission rate

The measurement was conducted under the conditions of the temperature of 40°C, humidity of 90%RH, and measurement area of 50 cm$^2$ by using a water vapor transmission rate measuring apparatus (model: DELTAPERM (Registered Trademark) manufactured by Technolox, GB). Sample number was 2 samples per level, and the measurement number was 5 times for the same sample. The measurement was conducted 5 times per sample, and the average of the resulting data was rounded off to the second decimal place to thereby determine the average of the sample. Similarly, the average of different sample was determined, and the two sample averages were further averaged and rounded off to the second decimal place for its use as the water vapor transmission rate(g/(m$^2$.24hr.atm)).
For the samples which is equal to or lower than the lower limit (1.0 x 10$^{-4}$ g/m$^2$.24hr.atm) of measurement by the DELTAPERM, the measurement was conducted under the conditions of the temperature of 40°C, humidity of 90%RH, and measurement area of 50 cm$^2$ by using a water vapor transmission rate measuring apparatus (model: Superdetect SKT (Registered Trademark) manufactured by MORESCO). Sample number was 2 samples per level, and the measurement number was 5 times for the same sample. The measurement was conducted 5 times per sample, and the average of the resulting data was rounded off to the second decimal place to thereby determine the average of the sample. Similarly, the average of different sample was determined, and the two sample averages were further averaged and rounded off to the second decimal place for its use as the water vapor transmission rate (g/(m$^2$.24hr.atm)).
For the samples which is equal to or lower than the lower limit (1.0 x 10$^{-4}$ g/m$^2$.24hr.atm) of measurement by the DELTAPERM, the measurement was also conducted under the conditions of the temperature of 60°C, humidity of 90%RH, and measurement area of 50 cm$^2$ by using DELTAPERM. Sample number was 2 samples per level, and the measurement number was 5 times for the same sample. The measurement was conducted 5 times per sample, and the average of the resulting data was rounded off to the second decimal place to thereby determine the average of the sample. Similarly, the average of different sample was determined, and the two sample averages were further averaged and rounded off to the second decimal place for its use as the water vapor transmission rate (g/(m$^2$.24hr.atm)).

(5) Hardness of the gas barrier layer

Hardness of the gas barrier layer was measured by nanoindentation method (continuous stiffness measurement). The nanoindentation method is a method wherein an indenter is minutely vibrated in the indentation test, response amplitude and phase difference in response to the vibration are obtained as a function of time, and initial gradient upon removal of the indenter is continuously calculated in response to continuous change of the indentation depth.

- apparatus used for the measurement:

    ultramicro-hardness tester, Nano Indenter DCM manufactured by MTS Systems

- method used for the measurement: nanoindentation method (continuous stiffness measurement)
- indenter used: diamond regular triangular pyramid indenter
- measurement atmosphere: room temperature, in the atmosphere

(6) Measurement of the film surface temperature

During the sputtering as described below, a thermocouple was adhered by using a heat-resistant tape to the center on the surface of the polymer film substrate with no exposure of the its metal part, and the surface temperature of the substrate was measured. In each level, the highest temperature on the surface of the polymer film substrate before the sputtering was measured, and this temperature was used for the measured temperature.

- apparatus (data logger): DQ1860 (manufactured by DATAPAQ)
- sampling frequency: 0.1 second
- thermocouple: type K

(7) Pencil hardness

The pencil hardness test (load, 500 g) defined in JIS K5600-5-4: 1999 was conducted. The highest hardness that left no failure was recorded.

(8) Measurement of FT-IR (Fourier Transform Infrared Spectroscopy)

FT-IR measurement of the gas barrier layer was conducted by ATR (attenuated total reflection). In each level, the polymer film substrate before and after the formation of the gas barrier layer was cut out, pressed onto ATR crystal, and the measurement was carried out twice for each case (n = 2). Difference spectrum of the spectrum before and after the formation of the gas barrier layer was obtained, and the peak at the wave number of 900 to 1,100 $cm^{-1}$ was subjected to peak separation to the wave numbers of 920 $cm^{-1}$ and 1,080 $cm^{-1}$ to determine integrated intensity of each peak. In this process, a straight line between spectrum values at 650 $cm^{-1}$ and 1,400 $cm^{-1}$ is depicted as a base line, and 2 Gaussian functions are set. Only the position of the peak of one Gaussian function was used as fixed value at 1,080 $cm^{-1}$, and the calculation was conducted. As a result of the calculation, the integrated intensity of the spectrum having its peak at 1,080 $cm^{-1}$ and the integrated intensity of the spectrum having its peak at 900 to 940 $cm^{-1}$ were regarded as the peak of 920 $cm^{-1}$ corresponding to the absorption of the Zn-O-Si bond, and the integrated intensity of the spectrum was respectively determined for the calculation of the ratio. Average of the measurements (n = 2) was used for the measurement result.

- apparatus: FTS-55a (manufactured by Bio-RadDIGILAB)
- light source: high intensity ceramics
- sensor: MCT
- purged with: nitrogen gas
- resolution: 4 $cm^{-1}$
- number of integration: 256
- measurement method: attenuated total reflection, ATR)
- measurement wavelength: 4,000 to 600 $cm^{-1}$
- attachment: single reflection ATR attachment (manufactured by Seagull, Harrick)
- ATR crystal: Ge prism
- incidence angle: 70 degrees
- software used for the analysis: GRAMS AI ver. 8.0

(manufactured by Thermo Electron Corporation)

(Example 1)

[Formation of anchor coat layer]

A polyethylene terephthalate film ("Lumilar" (Registered Trademark) U48 manufactured by Toray Industries, Inc. having an adhesion-facilitating layer on both surfaces) having a thickness of 125 $\mu$m was used for the polymer film substrate 1, and a coating composition A was prepared by diluting 100 parts by weight urethane acrylate (PHOLUCID 420C manufactured by Chugoku Marine Paints, Ltd.) with 70 parts by weight of toluene for use as a coating composition for forming an anchor coat layer on the polymer film substrate. Next, the coating composition A was coated on one surface of the polymer film substrate by using a microgravure coater (gravure line number, 200UR; gravure rotation ratio, 100%), drying at 60°C for 1 minute, and curing the coating by UV irradiation at 1.0 J/cm$^2$ to form an anchor coat layer having a thickness of 1 $\mu$m.

[Formation of gas barrier layer]

The side of the polymer film substrate 1 having the anchor coat layer formed thereon was subjected to sputtering with argon gas and oxygen gas by using a sputtering target having a zinc oxide/silicon dioxide/aluminum oxide weight ratio of 77/20/3 to form a gas barrier layer (thickness of the gas barrier layer, 150 nm).
This procedure was carried out as described below by using the leaf-type sputtering apparatus 4 having a structure shown in FIG. 3. First, a polymer film substrate 6 having an anchor coat layer formed thereon was placed on a substrate holder 5 of the leaf-type sputtering apparatus 4 having a sputtering target comprising a mixture containing zinc oxide, silicon dioxide, and aluminum oxide having a zinc oxide/silicon dioxide/aluminum oxide compositional ratio of 77/20/3 placed on the plasma electrode 8, and rotation of the substrate holder 5 was started at 20 rpm. Next, the pressure of the interior of the leaf-type sputtering apparatus 4 was reduced to the level of 1.0 x 10$^{-3}$ Pa or lower by using a vacuum pump, and simultaneously, heating with IR heater 7 was conducted so that surface temperature of the polymer film substrate 6 was 150°C. Next, argon gas and oxygen gas were introduced with the oxygen partial pressure of 20% so that the degree of vacuum was 2.0 x 10$^{-1}$ Pa. The plasma electrode 8 and the IR heater 7 were arranged so that the polymer film substrate 6 alternately passes past the plasma electrode 8 and the IR heater 7 with the rotation of the polymer film substrate 6, and the sputtering was conducted by generating argon/oxygen gas plasma by application of a power of 1, 500 W to the plasma electrode 8 by direct current while heating with the IR heater 7 to thereby form a gas barrier layer on the surface of the polymer film substrate 6.
Next, test pieces were cut out of the resulting gas barrier film, and XAFS, film hardness measurement, evaluation of sputtered layer by XRR, density evaluation, evaluation of compositional ratio by XPS, FT-IR measurement, and evaluation of water vapor transmission rate were conducted.
The results are shown in Table 1.

(Example 2)

A gas barrier film was obtained by repeating the procedure of Example 1 except that the anchor coat layer was provided by using a coating composition B prepared by adding 0.2 part by weight of silicone oil (SH190 manufactured by Dow Corning Toray Co., Ltd.) to 100 parts by weight of polyester acrylate (FOP-1740 manufactured by Nippon Kayaku Co., Ltd.) and diluting the mixture with 50 parts by weight of toluene and 50 parts by weight of MEK instead of the urethane acrylate, and coating the coating composition B by using a microgravure coater (gravure line number, 200UR; gravure rotation ratio, 100%), drying at 60°C for 1 minute, and curing the coating by UV irradiation at 1.0 J/cm$^2$ to form an anchor coat layer having a thickness of 1 $\mu$m.

(Example 3)

A gas barrier film was obtained by repeating the procedure of Example 1 except that the surface temperature of the polymer film substrate 6 before the sputtering was 100°C.

(Example 4)

A gas barrier film was obtained by repeating the procedure of Example 1 except that the surface temperature of the polymer film substrate 6 before the sputtering was 180°C.

(Example 5)

A gas barrier film was obtained by repeating the procedure of Example 1 except that the sputtering target used was the one having a compositional weight ratio (zinc oxide/silicon dioxide/aluminum oxide) of 89/8/3.

(Example 6)

A gas barrier film was obtained by repeating the procedure of Example 1 except that the sputtering target used was the one having a compositional weight ratio (zinc oxide/silicon dioxide/aluminum oxide) of 67/30/3.

(Example 7)

A gas barrier film was obtained by repeating the procedure of Example 1 except that the sputtering apparatus used was the winding-type sputtering apparatus 11 having the structure shown in FIG. 6(a).

First, a polymer film substrate 12 having an anchor coat layer formed thereon was set on a feed roll 13 in a take-up chamber of the winding-type sputtering apparatus 11 having sputtering targets comprising a mixture containing zinc oxide, silicon dioxide, and aluminum oxide having a zinc oxide/silicon dioxide/aluminum oxide compositional ratio of 77/20/3 placed on the plasma electrodes 27 to 31. The film substrate was then passed from the feed roll 13 via guide rolls 14, 15, and 16 to a main roll 17. Next, argon gas and oxygen gas were introduced with the oxygen partial pressure of 10% so that the degree of vacuum was $2.0 \times 10^{-1}$ Pa, and the sputtering was conducted by generating argon/oxygen gas plasma by application of a power of 3,000 W to the plasma electrode 27 to 31 by direct current while heating with the IR heaters 22 to 26 so that the surface temperature of the polymer film substrate 12 before the sputtering was 150°C. A gas barrier layer was thereby formed on the surface of the polymer film substrate 12 by sputtering. The polymer film substrate was then passed via guide rolls 18, 19, and 20, and wound on a take-up roll 21.

(Example 8)

A gas barrier film was obtained by repeating the procedure of Example 7 except that the anchor coat layer was provided by using a coating composition B prepared by adding 0.2 part by weight of silicone oil (SH190 manufactured by Dow Corning Toray Co., Ltd.) to 100 parts by weight of polyester acrylate (FOP-1740 manufactured by Nippon Kayaku Co. , Ltd.) and diluting the mixture with 50 parts by weight of toluene and 50 parts by weight of MEK instead of the urethane acrylate, and coating the coating composition B by using a microgravure coater (gravure line number, 200UR; gravure rotation ratio, 100%), drying at 60°C for 1 minute, and curing the coating by UV irradiation at 1.0 J/cm$^2$ to form an anchor coat layer having a thickness of 1 μm.

(Example 9)

A gas barrier film was obtained by repeating the procedure of Example 7 except that the coating composition for the formation of the anchor coat used was urethane acrylate KRM7735 manufactured by Daicel-Cytec LTD. instead of the urethane acrylate (PHOLUCID 420C manufactured by Chugoku Marine Paints, Ltd.).

(Example 10)

A gas barrier film was obtained by repeating the procedure of Example 7 except that the surface temperature of the polymer film substrate 12 before the sputtering was 100°C.

(Example 11)

A gas barrier film was obtained by repeating the procedure of Example 1 except that the surface temperature of the polymer film substrate 12 before the sputtering was 180°C.

(Example 12)

A gas barrier film was obtained by repeating the procedure of Example 7 except that the sputtering target used was the one having a compositional weight ratio (zinc oxide/silicon dioxide/aluminum oxide) of 89/8/3.

(Example 13)

A gas barrier film was obtained by repeating the procedure of Example 7 except that the sputtering target used was the one having a compositional weight ratio (zinc oxide/silicon dioxide/aluminum oxide) of 67/30/3.

(Example 14)

By using the winding-type sputtering apparatus having a structure shown in FIG. 6(b), the sputtering by argon gas and oxygen gas was conducted on the surface of the polymer film substrate 12 having the anchor coat layer formed thereon by repeating the procedure of Example 1 by placing a sputtering target which is a sintered mixture of zinc oxide, silicon dioxide, and aluminum oxide on the plasma electrode 33 to thereby form a gas barrier layer. This procedure was carried out as described below.

First, a polymer film substrate 12 was set on a feed roll 13 of the sputtering apparatus 11 having a sintered sputtering target having a zinc oxide/silicon dioxide/aluminum oxide compositional ratio of 77/20/3 placed on the plasma electrode 33 so that the surface of the polymer film substrate 12 on which the gas barrier layer is formed and the surface of the plasma electrode 33 on the side of the polymer film substrate opposes at a distance of 100 mm. The film substrate was then passed via feed side rolls 14, 15, and 16 to a main roll 17. The temperature of the main roll 17 was set at -20°C, and argon gas and oxygen gas were introduced with the oxygen partial pressure of 10% at the gas pressure of 1.5 x 10$^{-1}$ Pa, and the sputtering was conducted by generating argon/oxygen gas plasma by application of a power of 3,000 W by direct current. A gas barrier layer was thereby formed on the surface of the polymer film substrate 12 by sputtering. The thickness of the gas barrier layer was adjusted to 50 nm by regulating the film transfer speed. The polymer film substrate was then passed via guide rolls 18, 19, and 20, and wound on a take-up roll 21.

(Example 15)

A gas barrier film was obtained by repeating the procedure of Example 14 except that the main roll 17 was set at a temperature of 150°C.

(Example 16)

A gas barrier film was obtained by repeating the procedure of Example 14 except that the main roll 17 was set at a temperature of 100°C.

(Example 17)

A gas barrier film was obtained by repeating the procedure of Example 14 except that the main roll 17 was set at a temperature of 50°C.

(Example 18)

A gas barrier film was obtained by repeating the procedure of Example 14 except that the main roll 17 was set at a temperature of 0°C.

(Example 19)

A gas barrier film was obtained by repeating the procedure of Example 14 except that the gas pressure was set at 1.0 x 10$^{-1}$ Pa.

(Example 20)

A gas barrier film was obtained by repeating the procedure of Example 15 except that the gas pressure was set at 1.0 x 10$^{-1}$ Pa.

(Example 21)

A gas barrier film was obtained by repeating the procedure of Example 14 except that the distance between the polymer film substrate and the sputtering target was set at 50 mm.

(Example 22)

A gas barrier film was obtained by repeating the procedure of Example 15 except that the distance between the polymer film substrate and the sputtering target was set at 50 mm.

(Comparative Example 1)

A gas barrier film was obtained by repeating the procedure of Example 1 except that the surface temperature of the polymer film substrate 1 before the sputtering was 25°C.

(Comparative Example 2)

A gas barrier film was obtained by repeating the procedure of Example 5 except that the surface temperature of the polymer film substrate 12 before the sputtering was 25°C.

(Comparative Example 3)

A gas barrier film was obtained by repeating the procedure of Example 6 except that the surface temperature of the polymer film substrate 12 before the sputtering was 25°C.

(Comparative Example 4)

A gas barrier film was obtained by repeating the procedure of Example 7 except that the surface temperature of the polymer film substrate 12 before the sputtering was 25°C.

(Comparative Example 5)

A gas barrier film was obtained by repeating the procedure of Example 7 except that the sputtering target used was the one having a compositional weight ratio (zinc oxide/silicon dioxide/aluminum oxide) of 92/5/3.

(Comparative Example 6)

A gas barrier film was obtained by repeating the procedure of Example 14 except that the gas pressure was set at $2.0 \times 10^{-1}$ Pa.

(Comparative Example 7)

A gas barrier film was obtained by repeating the procedure of Example 14 except that the surface temperature of the polymer film substrate 12 before the sputtering was 210°C.

[Table 1-1]

[Table 1-1]

| | Target material | | Surface temperature of polymer film substrate before the sputtering [°C] | Polymer film substrate in the sputtering | | | Sputtering conditions | | |
|---|---|---|---|---|---|---|---|---|---|
| | Composition | Zn/Si[*1] | | (A) Temperature of the surface where the gas barrier layer is formed [°C] | (B)Temperature of the surface opposite to the surface where the gas barrier layer is formed [°C] | (A)-(B) [°C] | Gas pressure [Pa] | Distance between polymer film substrate and target [mm] | Main roll temperature [°C] |
| Example 1 | ZnO-Al$_2$O$_3$-SiO$_2$ | 2.8 | 150 | 160 | 150 | 10 | 0.20 | 90 | - |
| Example 2 | ZnO-Al$_2$O$_3$-SiO$_2$ | 2.8 | 150 | 160 | 150 | 10 | 0.20 | 90 | - |
| Example 3 | ZnO-Al$_2$O$_3$-SiO$_2$ | 2.8 | 100 | 110 | 100 | 10 | 0.20 | 90 | - |
| Example 4 | ZnO-Al$_2$O$_3$-SiO$_2$ | 2.8 | 180 | 190 | 180 | 10 | 0.20 | 90 | - |
| Example 5 | ZnO-Al$_2$O$_3$-SiO$_2$ | 8.0 | 150 | 160 | 150 | 10 | 0.20 | 90 | - |
| Example 6 | ZnO-Al$_2$O$_3$-SiO$_2$ | 1.8 | 150 | 160 | 150 | 10 | 0.20 | 90 | - |
| Example 7 | ZnO-Al$_2$O$_3$-SiO$_2$ | 2.8 | 150 | 160 | 120 | 40 | 0.20 | 100 | 25 |
| Example 8 | ZnO-Al$_2$O$_3$-SiO$_2$ | 2.8 | 150 | 160 | 120 | 40 | 0.20 | 100 | 25 |
| Example 9 | ZnO-Al$_2$O$_3$-SiO$_2$ | 2.8 | 150 | 160 | 120 | 40 | 0.20 | 100 | 25 |
| Example 10 | ZnO-Al$_2$O$_3$-SiO$_2$ | 2.8 | 100 | 110 | 70 | 40 | 0.20 | 100 | 25 |
| Example 11 | ZnO-Al$_2$O$_3$-SiO$_2$ | 2.8 | 180 | 190 | 150 | 40 | 0.20 | 100 | 25 |
| Example 12 | ZnO-Al$_2$O$_3$-SiO$_2$ | 8.0 | 150 | 160 | 120 | 40 | 0.20 | 100 | 25 |
| Example 13 | ZnO-Al$_2$O$_3$-SiO$_2$ | 1.8 | 150 | 160 | 120 | 40 | 0.20 | 100 | 25 |
| Example 14 | ZnO-Al$_2$O$_3$-SiO$_2$ | 2.8 | -20 | 30 | -20 | 50 | 0.15 | 100 | -20 |
| Example 15 | ZnO-Al$_2$O$_3$-SiO$_2$ | 2.8 | 140 | 180 | 140 | 40 | 0.15 | 100 | 150 |
| Example 16 | ZnO-Al$_2$O$_3$-SiO$_2$ | 2.8 | 90 | 135 | 90 | 45 | 0.15 | 100 | 100 |
| Example 17 | ZnO-Al$_2$O$_3$-SiO$_2$ | 2.8 | 45 | 95 | 45 | 50 | 0.15 | 100 | 50 |
| Example 18 | ZnO-Al$_2$O$_3$-SiO$_2$ | 2.8 | 0 | 50 | 0 | 50 | 0.15 | 100 | 0 |
| Example 19 | ZnO-Al$_2$O$_3$-SiO$_2$ | 2.8 | -20 | 30 | -20 | 50 | 0.1 | 100 | -20 |
| Example 20 | ZnO-Al$_2$O$_3$-SiO$_2$ | 2.8 | 140 | 180 | 140 | 40 | 0.1 | 100 | 150 |
| Example 21 | ZnO-Al$_2$O$_3$-SiO$_2$ | 2.8 | -20 | 50 | -20 | 70 | 0.15 | 50 | -20 |

EP 2 982 774 A1

| | Target material | | Surface temperature of polymer film substrate before the sputtering [°C] | Polymer film substrate in the sputtering | | | Sputtering conditions | | |
|---|---|---|---|---|---|---|---|---|---|
| | Composition | Zn/Si[*1] | | (A) Temperature of the surface where the gas barrier layer is formed [°C] | (B)Temperature of the surface opposite to the surface where the gas barrier layer is formed [°C] | (A)-(B) [°C] | Gas pressure [Pa] | Distance between polymer film substrate and target [mm] | Main roll temperature [°C] |
| Example 22 | $ZnO\text{-}Al_2O_3\text{-}SiO_2$ | 2.8 | 145 | 220 | 145 | 75 | 0.15 | 50 | 150 |
| Comparative Example 1 | $ZnO\text{-}Al_2O_3\text{-}SiO_2$ | 2.8 | 25 | 60 | 45 | 15 | 0.20 | 90 | - |
| Comparative Example 2 | $ZnO\text{-}Al_2O_3\text{-}SiO_2$ | 8.0 | 25 | 60 | 45 | 15 | 0.20 | 90 | - |
| Comparative Example 3 | $ZnO\text{-}Al_2O_3\text{-}SiO_2$ | 1.8 | 25 | 60 | 45 | 15 | 0.20 | 90 | - |
| Comparative Example 4 | $ZnO\text{-}Al_2O_3\text{-}SiO_2$ | 2.8 | 25 | 60 | 25 | 35 | 0.20 | 100 | 25 |
| Comparative Example 5 | $ZnO\text{-}Al_2O_3\text{-}SiO_2$ | 17.0 | 150 | 160 | 120 | 40 | 0.20 | 100 | 25 |
| Comparative Example 6 | $ZnO\text{-}Al_2O_3\text{-}SiO_2$ | 2.8 | -20 | 30 | -20 | 50 | 0.20 | 100 | -20 |
| Comparative Example 7 | $ZnO\text{-}Al_2O_3\text{-}SiO_2$ | 2.8 | 210 | 210 | 170 | 40 | 0.20 | 100 | 25 |

*1: "Zn/Si" represents the proportion obtained by dividing zinc atomic concentration by silicon atomic concentration.

EP 2 982 774 A1

[Table 1-2]

[Table 1-2]

[Table 1-2]

| | Gas barrier layer | | | | | | | | | Anchor coat layer | Gas barrier film | | | |
| | XANES spectrum[*2] 9669.0e V/ 9668.0e V | Radial distribution function[*3] 0.28nm/ 0.155nm | Film hardness [GPa] | Zn/Si[*1] | XRR density[*4] [g/cm$^3$] | XPS density[*5] [g/cm$^3$] | Structural density index | FT-IR Ratio (A/B) of integrated intensity of the spectrum having its peak at 920 cm$^{-1}$ (A) to integrated intensity of the spectrum having its peak at 1,080 cm$^{-1}$ (B) | Thickness [nm] | Pencil Hardness | Appearance | Water vapor transmission rate [g/(m$^2$.24hr.atm)] | | |
| | | | | | | | | | | | | DELTA-PERM (40°C, 90%RH) | DELTAPERM (60°C, 90%RH) | Superdetect SKT |
|---|---|---|---|---|---|---|---|---|---|---|---|---|---|---|
| Example 1 | 0.937 | 0.12 | 0.92 | 0.6 | 3.99 | 3.08 | 1.30 | 2.5 | 150 | 2H | No problem | $<1.0 \times 10^{-4}$ | $6.7 \times 10^{-4}$ | $6.3 \times 10^{-6}$ |
| Example 2 | 0.930 | 0.12 | 0.89 | 0.5 | 3.99 | 2.97 | 1.34 | 2.4 | 150 | 3H | No problem | $<1.0 \times 10^{-4}$ | $4.9 \times 10^{-4}$ | $3.9 \times 10^{-6}$ |
| Example 3 | 0.934 | 0.10 | 1.51 | 1.0 | 4.35 | 3.43 | 1.27 | 4.2 | 150 | 2H | No problem | $<1.0 \times 10^{-4}$ | $3.5 \times 10^{-4}$ | $4.5 \times 10^{-6}$ |
| Example 4 | 0.950 | 0.13 | 0.88 | 0.3 | 3.72 | 2.80 | 1.33 | 1.6 | 150 | 2H | No problem | $<1.0 \times 10^{-4}$ | $9.4 \times 10^{-4}$ | $8.1 \times 10^{-6}$ |
| Example 5 | 0.932 | 0.12 | 0.90 | 0.8 | 4.13 | 3.26 | 1.27 | 2.7 | 150 | 2H | No problem | $<1.0 \times 10^{-4}$ | $1.1 \times 10^{-3}$ | $9.2 \times 10^{-6}$ |
| Example 6 | 0.948 | 0.14 | 0.97 | 0.3 | 3.76 | 2.76 | 1.36 | 1.3 | 150 | 2H | No problem | $<1.0 \times 10^{-4}$ | $4.7 \times 10^{-4}$ | $3.4 \times 10^{-6}$ |
| Example 7 | 0.934 | 0.12 | - | 0.5 | 3.93 | 3.05 | 1.29 | 2.2 | 150 | 2H | No problem | $<1.0 \times 10^{-4}$ | $7.0 \times 10^{-4}$ | $6.1 \times 10^{-6}$ |
| Example 8 | 0.921 | 0.11 | - | 0.5 | 3.95 | 3.00 | 1.32 | 2.0 | 150 | 3H | No problem | $<1.0 \times 10^{-4}$ | $6.4 \times 10^{-4}$ | $5.4 \times 10^{-6}$ |
| Example 9 | 0.913 | 0.11 | - | 0.5 | 3.64 | 3.01 | 1.21 | 2.7 | 150 | HB | No problem | $<1.0 \times 10^{-4}$ | $3.9 \times 10^{-3}$ | $3.2 \times 10^{-5}$ |
| Example 10 | 0.917 | 0.11 | - | 0.9 | 4.15 | 3.36 | 1.24 | 4.5 | 150 | 2H | No problem | $<1.0 \times 10^{-4}$ | $1.7 \times 10^{-3}$ | $2.1 \times 10^{-5}$ |
| Example 11 | 0.955 | 0.14 | - | 0.2 | 3.53 | 2.66 | 1.33 | 1.5 | 150 | 2H | No problem | $<1.0 \times 10^{-4}$ | $6.1 \times 10^{-4}$ | $5.5 \times 10^{-6}$ |
| Example 12 | 0.930 | 0.11 | - | 0.7 | 4.08 | 3.21 | 1.27 | 2.8 | 150 | 2H | No problem | $<1.0 \times 10^{-4}$ | $8.5 \times 10^{-4}$ | $7.2 \times 10^{-6}$ |

(continued)

| | Gas barrier layer | | | | | | | | | Anchor coat layer | Gas barrier film | | | |
|---|---|---|---|---|---|---|---|---|---|---|---|---|---|---|
| | | | | | | | | | | | | Water vapor transmission rate [g/(m2.24hr.atm)] | | |
| | XANES spectrum*2 9669.0e V/ 9668.0e V | Radial distribution function*3 0.28nm/ 0.155nm | Film hardness [GPa] | Zn/Si*1 | XRR density*4 [g/cm3] | XPS density*5 [g/cm3] | Structural density index | FT-IR Ratio (A/B) of integrated intensity of the spectrum having its peak at 920 cm-1 (A) to integrated intensity of the spectrum having its peak at 1,080 cm-1 (B) | Thickness [nm] | Pencil Hardness | Appearance | DELTA-PERM (40°C, 90%RH) | DELTAPERM (60°C, 90%RH) | Superdetect SKT |
| Example 13 | 0.942 | 0.14 | - | 0.3 | 3.85 | 2.83 | 1.33 | 1.5 | 150 | 2H | No problem | <1.0 × 10-4 | 5.2 × 10-4 | 4.8 × 10-6 |
| Example 14 | 0.873 | 0.06 | - | 2.7 | 4.20 | 4.34 | 1.03 | 6.7 | 50 | 2H | No problem | 6.6 × 10-4 | - | - |
| Example 15 | 0.937 | 0.11 | - | 1.9 | 3.93 | 4.44 | 1.13 | 1.5 | 50 | 2H | No problem | 3.2 × 10-4 | - | - |
| Example 16 | 0.913 | 0.08 | - | 2.2 | 4.01 | 4.42 | 1.10 | 2.3 | 50 | 2H | No problem | 2.8 × 10-4 | - | - |
| Example 17 | 0.904 | 0.07 | - | 2.5 | 4.13 | 4.46 | 1.08 | 4.0 | 49 | 2H | No problem | 4.6 × 10-4 | - | - |
| Example 18 | 0.867 | 0.07 | - | 2.5 | 4.14 | 4.37 | 1.06 | 5.3 | 50 | 2H | No problem | 5.0 × 10-4 | - | - |
| Example 19 | 0.882 | 0.07 | - | 2.7 | 4.20 | 4.42 | 1.05 | 6.0 | 51 | 2H | No problem | 5.3 × 10-4 | - | - |
| Example 20 | 0.942 | 0.13 | - | 1.9 | 3.89 | 4.47 | 1.15 | 1.2 | 51 | 2H | No problem | 2.5 × 10-4 | - | - |
| Example 21 | 0.902 | 0.10 | - | 2.3 | 4.07 | 4.33 | 1.06 | 5.3 | 50 | 2H | No problem | 5.6 × 10-4 | - | - |
| Example 22 | 0.952 | 0.13 | - | 1.7 | 3.80 | 4.40 | 1.16 | 1.1 | 51 | 2H | No problem | 2.5 × 10-4 | - | - |

(continued)

| | Gas barrier layer | | | | | | | | Anchor coat layer | | Gas barrier film | | |
|---|---|---|---|---|---|---|---|---|---|---|---|---|---|
| | XANES spectrum[*2] 9669.0e V/ 9668.0e V | Radial distribution function[*3] 0.28nm/ 0.155nm | Film hardness [GPa] | Zn/Si[*1] | XRR density[*4] [g/cm$^3$] | XPS density[*5] [g/cm$^3$] | Structural density index | FT-IR Ratio (A/B) of integrated intensity of the spectrum having its peak at 920 cm$^{-1}$ (A) to integrated intensity of the spectrum having its peak at 1,080 cm$^{-1}$ (B) | Thickness [nm] | Pencil Hardness | Appearance | Water vapor transmission rate [g/(m$^2$.24hr.atm)] | | |
| | | | | | | | | | | | | DELTA-PERM (40°C, 90%RH) | DELTAPERM (60°C, 90%RH) | Superdetect SKT |
| Comparative Example 1 | 0.900 | 0.08 | 3.10 | 1.7 | 4.55 | 3.84 | 1.18 | 7.4 | 150 | 2H | No problem | $4.8 \times 10^{-4}$ | - | - |
| Comparative Example 2 | 0.886 | 0.07 | 2.95 | 3.0 | 4.49 | 3.77 | 1.19 | 7.6 | 150 | 2H | No problem | $2.5 \times 10^{-3}$ | - | - |
| Comparative Example 3 | 0.906 | 0.09 | 3.12 | 1.6 | 5.60 | 5.02 | 1.12 | 7.3 | 150 | 2H | No problem | $3.0 \times 10^{-4}$ | - | - |
| Comparative Example 4 | 0.880 | 0.07 | - | 1.4 | 4.41 | 3.79 | 1.16 | 7.4 | 150 | 2H | No problem | $5.1 \times 10^{-4}$ | - | - |
| Comparative Example 5 | 0.871 | 0.06 | - | 2.1 | 5.55 | 4.27 | 1.30 | 7.9 | 150 | 2H | No problem | $1.7 \times 10^{-1}$ | - | - |

(continued)

| | Gas barrier layer | | | | | | | | | Anchor coat layer | | Gas barrier film | | |
|---|---|---|---|---|---|---|---|---|---|---|---|---|---|---|
| | | | | | | | | | | | | | Water vapor transmission rate [g/(m$^2$.24hr.atm)] | |
| | XANES spectrum*2 9669.0e V/ 9668.0e V | Radial distribution function*3 0.28nm/ 0.155nm | Film hardness [GPa] | Zn/Si*1 | XRR density*4 [g/cm$^3$] | XPS density*5 [g/cm$^3$] | Structural density index | FT-IR Ratio (A/B) of integrated intensity of the spectrum having its peak at 920 cm$^{-1}$ (A) to integrated intensity of the spectrum having its peak at 1,080 cm$^{-1}$ (B) | Thickness [nm] | Pencil Hardness | Appearance | DELTA-PERM (40°C, 90%RH) | DELTAPERM (60°C, 90%RH) | Superdetect SKT |
| Comparative Example 6 | 0.869 | 0.06 | | 3.1 | 4.30 | 4.33 | 1.01 | 7.3 | 50 | 2H | No problem | 1.3 × 10$^{-3}$ | - | - |
| Comparative Example 7 | Not measurable | Not measurable | Not measurable | Not measurable | 3.93 | Not measurable | Not measurable | 0.8 | 50 | 2H | Whitening | Not measurable | Not measurable | Not measurable |

*1: "Zn/Si" represents the proportion obtained by dividing zinc atomic concentration by silicon atomic concentration.

*2: "XANES spectrum" represents (spectrum intensity at 9664.0 eV) / (spectrum intensity at 9668.0 eV) in XANES spectrum.

*3: "Radial distribution function" represents (spectrum intensity at 0.28 nm) / (spectrum intensity at 0.155 nm) in radial distribution function of EXAFS.

*4: "XRR density" represents density of the gas barrier layer determined by X-ray reflectometry (XRR).

*5: "XPS density" represents theoretical density calculated from the compositional ratio determined by X-ray photoelectron spectroscopy (XPS).

EP 2 982 774 A1

27

Explanation of Numerals

| 1 | polymer film substrate |
|---|---|
| 2 | gas barrier layer |
| 3 | anchor coat layer |
| 4 | leaf-type sputtering apparatus |
| 5 | substrate holder |
| 6 | polymer film substrate |
| 7, 10 | IR heater |
| 8, 9 | plasma electrode |
| 11 | winding-type sputtering apparatus |
| 12 | polymer film substrate |
| 13 | feed roll |
| 14, 15, 16 | feed-side guide roll |
| 17 | main roll |
| 18, 19, 20 | take up-side guide roll |
| 21 | take-up roll |
| 22, 23, 24, 25, 26, 32 | IR heater |
| 27, 28, 29, 30, 31, 33 | plasma electrode |

**Claims**

1. A gas barrier film comprising a polymer film substrate and a gas barrier layer containing at least zinc oxide and silicon dioxide on at least one surface of the polymer film substrate, wherein the gas barrier layer satisfies at least one of the following [I] to [III]:

    [I] with regard to X-ray absorption near edge structure (XANES) spectrum at K absorption edge of zinc, the value of (spectrum intensity at 9664.0 eV) / (spectrum intensity at 9668.0 eV) is in the range of 0.910 to 1.000;
    [II] the value obtained by dividing atomic concentration of zinc with atomic concentration of silicon is in the range of 0.1 to 1.5, and structural density index represented by the following equation:

$$\text{structural density index} = \{\text{density of the gas barrier layer obtained by X-ray reflectometry (XRR)}\} / \{(\text{theoretical density calculated from compositional ratio determined by X-ray photoelectron spectroscopy (XPS)}\} \text{ is } 1.20 \text{ to } 1.40; \text{ and}$$

    [III] when peak in the wave number range of 900 to 1,100 cm$^{-1}$ measured in FT-IR measurement is subjected to peak separation into the wave number of 920 cm$^{-1}$ and the wave number of 1, 080 cm$^{-1}$, the value of ratio (A/B) of integrated intensity of the spectrum having its peak at 920 cm$^{-1}$ (A) to integrated intensity of the spectrum having its peak at 1,080 cm$^{-1}$ (B) is at least 1.0 and up to 7.0.

2. A gas barrier film according to claim 1 wherein, in radial distribution function obtained by Fourier transformation of the extended X-ray Absorption Fine Structure (EXAFS) spectrum at K absorption edge of zinc in the gas barrier layer, the value of (spectrum intensity at 0.28 nm) / (spectrum intensity at 0.155 nm) is 0.08 to 0.20.

3. A gas barrier film according to claim 1 or 2 wherein the gas barrier layer has a hardness of 0.8 to 1.8 GPa.

4. A gas barrier film according to any one of claims 1 to 3 wherein the gas barrier layer has a density as measured by X-ray reflectometry of 1 to 7 g/cm$^3$.

5. A gas barrier film according to any one of claims 1 to 4 wherein the gas barrier layer contains aluminum oxide.

**6.** A gas barrier film according to any one of claims 1 to 5 wherein the film has an anchor coat layer between the polymer film substrate and the gas barrier layer.

**7.** A gas barrier film according to claim 5 or 6 wherein the gas barrier layer has a zinc (Zn) atomic concentration of 1 to 35 atm%, a silicon (Si) atomic concentration of 5 to 25 atm%, an aluminum (Al) atomic concentration of 1 to 7 atm%, and an oxygen (O) atomic concentration of 50 to 70 atm% when measured by X-ray photoelectron spectroscopy.

**8.** A method for producing a gas barrier film comprising a polymer film substrate and a gas barrier layer containing at least zinc oxide and silicon dioxide on at least one surface of the polymer film substrate wherein, after adjusting the polymer film substrate surface to a temperature of 40 to 200°C, sputtering is conducted by using a target material containing zinc oxide and silicon dioxide wherein the value obtained by dividing atomic concentration of zinc with atomic concentration of silicon is in the range of 1.4 to 8.5 to form the gas barrier layer.

**9.** A method for producing a gas barrier film comprising a polymer film substrate and a gas barrier layer containing at least zinc oxide and silicon dioxide on at least one surface of the polymer film substrate wherein sputtering is conducted under the pressure of oxygen-containing gas of less than 0.20 Pa to form the gas barrier layer.

**10.** A method for producing a gas barrier film according to claim 9 wherein the polymer film substrate in the sputtering satisfies the following (1) and (2):

(1) temperature of the surface opposite to the surface where the gas barrier layer is formed is at least -20°C and up to 150°C, and
(2) (temperature of the surface where the gas barrier layer is formed) - (temperature of the surface opposite to the surface where the gas barrier layer is formed) ≤ 100 (°C).

**11.** A method for producing a gas barrier film according to any one of claims 8 to 10 wherein the target material contains aluminum.

**12.** A method for producing a gas barrier film according to any one of claims 8 to 11 wherein sputtering is conducted on the anchor coat layer of the substrate having the anchor coat layer.

**13.** A method for producing a gas barrier film according to claim 11 or 12 wherein the target material has a zinc (Zn) atomic concentration of 3 to 37 atm%, a silicon (Si) atomic concentration of 5 to 20 atm%, an aluminum (Al) atomic concentration of 1 to 7 atm%, and an oxygen (O) atomic concentration of 50 to 70 atm%.

[Fig. 1]

[Fig. 1]

[Fig. 2]

[Fig. 2]

[Fig. 3]

[Fig. 3]

[Fig. 4]

[Fig. 4]

6

5

[Fig. 5]

[Fig. 5]

9

10

[Fig. 6]

[Fig. 6]

(a)

(b)

[Fig. 7]

[Fig. 7]

XANES spectrum at K edge of Zn (Examples)

[Fig. 8]

[Fig. 8]

XANES spectrum at K edge of Zn (Comparative Examples)

Comparative
Example 1
Comparative
Example 2
Comparative
Example 3

[Fig. 9]

[Fig. 9]

Radial distribution function obtained from EXAFS spectrum

[Fig. 10]

[Fig. 10]

Radial distribution function obtained from EXAFS spectrum at K edge of Zn (Comparative Examples)

**INTERNATIONAL SEARCH REPORT**

| International application No. |
|---|
| PCT/JP2014/059178 |

| A. CLASSIFICATION OF SUBJECT MATTER |
|---|
| *C23C14/08*(2006.01)i, *B32B9/00*(2006.01)i |

According to International Patent Classification (IPC) or to both national classification and IPC

| B. FIELDS SEARCHED |
|---|

Minimum documentation searched (classification system followed by classification symbols)
C23C14/08, B32B9/00

Documentation searched other than minimum documentation to the extent that such documents are included in the fields searched

| Jitsuyo Shinan Koho | 1922–1996 | Jitsuyo Shinan Toroku Koho | 1996–2014 |
|---|---|---|---|
| Kokai Jitsuyo Shinan Koho | 1971–2014 | Toroku Jitsuyo Shinan Koho | 1994–2014 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| Y<br>A | JP 2013-47363 A (Mitsubishi Materials Corp.),<br>07 March 2013 (07.03.2013),<br>claims; paragraphs [0041], [0047], [0058] to<br>[0063], [0071]<br>& CN 102965629 A | 1-9,11-13<br>10 |
| Y | WO 2013/035689 A1 (Toray Industries, Inc.),<br>14 March 2013 (14.03.2013),<br>paragraphs [0026], [0139], [0140], [0145]<br>& TW 201323207 A | 1-9,11-13 |

| ☐ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 17 April, 2014 (17.04.14) | 28 April, 2014 (28.04.14) |

| Name and mailing address of the ISA/<br>Japanese Patent Office | Authorized officer |
|---|---|
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005324406 A
- JP 2002113826 A
- JP 2008246893 A
- JP 2013047363 A
- JP 2009024255 A